# EUROPÄISCHE PATENTSCHRIFT

(11) **EP 4 587 447 B1**
(45) Veröffentlichungstag und Bekanntmachung des Hinweises auf die Patenterteilung: **05.08.2026**
(21) Anmeldenummer: 24748256.5
(22) Anmeldetag: 21.07.2024
(51) Int. Cl.: C07F 17/00, C23C 16/34, C23C 16/18, C23C 16/455, C23C 16/40

(54) **HETEROLEPTISCHE TRIAZENID-METALLKOMPLEXE**
HETEROLEPTIC TRIAZENIDE METAL COMPLEXES
COMPLEXES MÉTALLIQUES HÉTÉROLEPTIQUES DE TRIAZÉNIDE

(30) Priorität: 21.07.2023 DE 102023119428
(43) Veröffentlichungstag der Anmeldung: 23.07.2025
(73) Patentinhaber: Dockweiler Chemicals GmbH, 35041 Marburg (DE)
(72) Erfinder: BALMER, Markus, 35274 Kirchhain (DE); BRIEL, Oliver, 63755 Alzenau (DE); KAPITEIN, Manuel, 35039 Marburg (DE); HERRITSCH, Susanne Elisa, 35039 Marburg (DE)
(74) Vertreter: Stephan, Friederike
(86) Internationale Anmeldenummer: PCT/DE2024/100649
(87) Internationale Veröffentlichungsnummer: WO 2025/021255

(56) Entgegenhaltungen:
- WO-A1-2019/115646
- WO-A2-2004/063233
- US-A1- 2014 335 702
- CAROFF CHRISTOPHER M. ET AL: "Synthesis, Structure, and Properties of Volatile Lanthanide Dialkyltriazenides", INORGANIC CHEMISTRY, vol. 61, no. 42, 7 October 2022 (2022-10-07), Easton , US, pages 16740 - 16749, XP093214258, ISSN: 0020-1669, Retrieved from the Internet <URL:https://pubs.acs.org/doi/pdf/10.1021/acs.inorgchem.2c02545> DOI: 10.1021/acs.inorgchem.2c02545
- PFEIFFER ERNST ET AL: "Isostructural Triazenido Complexes of First Row Transition Metals. Part 1. Synthesis and Properties of (IlS-CsHs)(L)(RN3 R) Fe n, L = PPh3, P(OMe)3, P(OPh)3 or CO", TRANSITION METAL CHEMISTRY, vol. 4, 1 January 1979 (1979-01-01), pages 385 - 388, XP093214306, Retrieved from the Internet <URL:https://doi.org/10.1007/BF00623984> DOI: 10.1007/BF00623984

## Beschreibung

Homoleptische und heteroleptische Metallkomplexe, welche wenigstens einen Stickstoff enthaltenden Liganden aufweisen, Verfahren zu ihrer Herstellung sowie ihre Verwendung als Präkursoren in chemischen Gasphasenabscheidungsprozessen sind im Stand der Technik bekannt.

Im Bereich der Elektrotechnologie, insbesondere im Bereich der Halbleitertechnologie, rückt die Erzeugung hochreiner Schichten, welche beispielsweise ein Lanthanoid(III)-Oxid, ein Lanthanoid(III) enthaltendes Mischoxid oder einen Lanthanoid (Ln) enthaltenden III-V-Verbindungshalbleiter umfassen oder aus einem solchen Material bestehen, zunehmend in den Fokus des Interesses. Die Abscheidung solcher Metallschichten oder Metall enthaltender Schichten auf Oberflächen von Substraten kann zum Beispiel mittels metallorganischer Gasphasenabscheidungsverfahren (engl. *metal organic chemical vapor deposition,* MOCVD), Atomlagenabscheidungsverfahren (engl. *atomic layer deposition,* ALD) oder Gasphasenepitaxieverfahren (engl. *metal organic chemical vapor phase epitaxy,* MOVPE) erfolgen.

An dieser Stelle und im Folgenden wird auf die Angabe einer exakten Stöchiometrie einer Metallschicht, eines Metallfilms, einer Metall enthaltenden Schicht oder eines Metall enthaltenden Films verzichtet. Die Begriffe Schicht und Film werden synonym verwendet, wobei keines dieser Wörter eine Angabe hinsichtlich der Schichtdicke oder der Filmdicke umfasst.

In WO 2004/063233 A2 ist ein Polymerisationskatalysator offenbart, umfassend eine Stickstoff enthaltende Übergangsmetallverbindung gemäß der Formel (R¹-N₃-R²)ₙ(X)_{y}(L)_{z}M und einen Organoaluminium- oder Hydrocarbylboron-Aktivator. Dabei sind R¹ und R² entweder monovalente Gruppen oder bilden gemeinsam eine divalente Gruppe R³, welche die endständigen Stickstoffatome der Triazenideinheit über Kohlenstoffatome verbrückt. R¹ und R² und die divalente Gruppe R³ sind (i) aliphatischer Kohlenwasserstoff, (ii) alicyclischer Kohlenwasserstoff, (iii) aromatischer Kohlenwasserstoff, (iv) alkylsubstituierter aromatischer Kohlenwasserstoff, (v) heterocyclische Gruppen und (vi) heterosubstituierte Derivate der vorgenannten Gruppen (i) bis (v); M ist ein Metall aus der Gruppe 3 bis 11 des Periodensystems oder ein Lanthanoidenmetall; X ist eine anionische Gruppe, L ist eine neutrale Donorgruppe; n ist 1 oder 2, y und z sind unabhängig voneinander Null oder ganze Zahlen, sodass die Anzahl der Gruppen X und L der Valenz und dem Oxidationszustand des Metalls M genügen.

C. M. Caroff und G. S. Girolami (Inorg. Chem. 2022, 61 (42), 16740 - 16749) beschreiben die Synthese von Dialkyltriazenidkomplexen der Lanthanoidelemente Neodym, Europium und Erbium, nämlich der Verbindung Er(Bu^{t}N₃Bu^{t})₃, der Tetrahydrofuran-Monoaddukte Ln(Bu^{t}N₃Bu^{t})₃(THF), wobei Ln = Nd oder Eu, und der Lithiumsalze [Li(THF)][Ln(MeN₃Bu^{t})₄], wobei Ln = Eu oder Er.

E. Pfeiffer und K. Vrieze (Transition Met. Chem. 1979, 4, 385 - 388) stellen die Synthese von Triazenidokomplexen der Formel (*η*⁵-C₅H₅)(L)(RN₃R')Fe vor, ausgehend von geeigneten Eisenhalogeniden und Ag(RN₃R'). Dabei ist L = PPh₃, P(OMe)₃, P(OPh)₃ oder CO und R, R' = *p*-MeC₆H₄ oder *p*-CLC₆H₄.

In US 2014/0335702 A1 sind Lanthanoid enthaltende Präkursoren gemäß der allgemeinen Formel Ln(R¹Cp)*ₘ*(R²-N-C(R⁴)=N-R²)*ₙ* offenbart sowie ein Verfahren zur Abscheidung eines Lanthanoid enthaltenden Films auf einem Halbleitersubstrat unter Verwendung eines solchen Präkursors. Dabei gilt: Ln = Sc, Y, La, Ce, Pr, Nd, Sm, Eu, Gd, Tb, Dy, Ho, Er, Tm, Yb, Lu; R¹ und R² sind unabhängig voneinander ausgewählt aus der Gruppe bestehend aus H und C1-C5-Alkylketten; R⁴ = H oder Me; *m* und *n* liegen im Bereich von 1 bis 2. Und jeder Präkursor weist einen Schmelzpunkt unterhalb von etwa 105 °C auf. Ausführungsbeispiele sind ausschließlich für *m* = 2 und *n* = 1 gezeigt, also nur für Ln(III)-Komplexe, welche jeweils zwei monosubstituierte Cyclopentadienylliganden, wobei R¹ = Me, Et oder iPr ist, und einen Amidinatliganden umfassen. Die angegebenen Synthesevorschriften betreffen überwiegend Präkursoren, die jeweils einen *N,N'*-dialkylsubstituierten Acetamidinatliganden aufweisen, wobei R¹ = R² = iPr oder tBu ist und R⁴ = Me ist. Weitere Vorschriften sind für die Darstellung von Komplexen mit jeweils einem *N,N'*-dialkylsubstituierten Formamidinatliganden, wobei R¹ = R² = *i*Pr ist und R⁴ = H ist, formuliert.

Unvorteilhaft an diesen Ln(III)-Komplexen, welche einen oder zwei Amidinatliganden, insbesondere wenigstens einen Acetamidinatliganden aufweisen, ist der im Grundgerüst N-C(R⁴)=N des Liganden enthaltene Kohlenstoff. Dies gilt vor allem mit Blick auf die Verwendung dieser heteroleptischen Ln(III)-Komplexe als Präkursoren in chemischen Gasphasenabscheidungsverfahren. Denn es besteht eine nicht unerhebliche Wahrscheinlichkeit, dass die erzeugte Ln-Schicht oder Ln enthaltende Schicht durch Kohlenstoff verunreinigt ist und somit für die jeweils angestrebte Anwendung, insbesondere im Halbleiterbereich, unbrauchbar ist.

WO 2019/115646 A1 betrifft Metallkomplexe, die mindestens einen Liganden L der Formel R¹-N₃-R² aufweisen, wobei R¹ und R² Kohlenwasserstoffreste sind, sowie deren Verwendung zur Abscheidung des Metalls oder einer Verbindung des Metalls aus der Gasphase. Für die Gruppe der Lanthanoide sind zwei Beispiele gezeigt: [La(*t*Bu-N₃-*t*Bu)₃] (vgl. Seite 37, Beispiel 10) und [Ce(*t*Bu-N₃-*t*Bu)₃] (vgl. Seite 52, Beispiel 28). Diese homoleptischen Lanthanoid(III)-Komplexe besitzen jeweils ein relativ hohes Molekulargewicht von mehr als 600 g/mol (ca. 608 g/mol).

Während die Darstellung des homoleptischen Cer(III)-Komplexes durch Umsetzung von CeCl₃ mit Li(*t*Bu-N₃-*t*Bu) erfolgte, wurde der homoleptische Lanthan(III)-Komplex ausgehend von [La(hmds)₃] (hmds = Hexamethyldisilazid) und *t*Bu-HN₃-*t*Bu hergestellt. Laut thermogravimetrischer Untersuchung enthielt das Produkt noch Restspuren von Hexamethyldisilazid; ein Schmelzprozess setzte ab einer Temperatur von 103 °C ein (vgl. Seite 38).

Die Schmelztemperatur von ca. 100 °C und insbesondere das relativ hohe Molekulargewicht von mehr als 600 g/mol legen die Vermutung nahe, dass dieser Lanthan(III)-triazenidkomplex einen relativ geringen Dampfdruck besitzt. Ein Material, welches die vorgenannten Eigenschaften und eine damit üblicherweise einhergehende geringe Volatilität besitzt, ist für die Verwendung als Präkursor in einem chemischen Gasphasenabscheidungsprozess eher unvorteilhaft (vgl. auch WO 2019/115646 A1, Anspruch 21). Die Gründe dafür sind vielfältig: Zum einen sind bei Einsatz eines wenig volatilen Materials in der Regel Prozessbedingungen erforderlich, welche eine für viele Endanwendungen unzureichende Qualität der erzeugten Metallschicht oder Metall enthaltenden Schicht zur Folge haben. Insbesondere sind hohe Temperaturen notwendig, zu deren Erzeugung unvorteilhafterweise ein aufwändiges und somit kostenintensives Heizsystem benötigt wird. Der zusätzliche apparative Aufwand sowie der erhöhte Energieverbrauch wirken sich negativ auf die ökonomische und ökologische Bilanz des Verfahrens aus. Im Falle der thermischen Zersetzung eines homoleptischen Präkursors, wie beispielsweise [La(*t*Bu-N₃-*t*Bu)₃], kann es außerdem zu einem erhöhten Einbau parasitärer Verunreinigungen in die Halbleiterschicht kommen, beispielsweise in Form von Kohlenstoff, wodurch die Schichtqualität weiter verschlechtert wird.

Nach alledem sind die vorbekannten Präkursormaterialien für chemische Gasphasenabscheidungsprozesse unter ökologischen und (atom-)ökonomischen Gesichtspunkten als unbefriedigend einzustufen.

Der Erfindung liegt daher die Aufgabe zugrunde, diese und weitere Nachteile des Standes der Technik zu überwinden und Metallkomplexe zur Verfügung zu stellen, welche ein für die Elektroindustrie, insbesondere für die Halbleiterindustrie, relevantes Metall, nämlich Scandium, Yttrium, ein Lanthanoid oder Titan, enthalten und den an Präkursormaterialien für chemische Gasphasenabscheidungsverfahren gestellten Anforderungen genügen. Insbesondere sollen sich die Metallkomplexe durch eine hohe Reinheit und einen relativ hohen Dampfdruck auszeichnen und sich als Präkursoren für die Erzeugung qualitativ hochwertiger Metallschichten oder Metall enthaltender Schichten eignen. Zudem sollen die Metallkomplexe einfach, effizient, reproduzierbar und möglichst kostengünstig in hoher Reinheit und in guten Ausbeuten, auch im industriellen Maßstab, herstellbar sein. Des Weiteren betrifft die Erfindung ein Verfahren zur Herstellung einer Schicht, welche aus wenigstens einem Metall besteht oder wenigstens ein Metallenthält, wobei das Metall Scandium, Yttrium, ein Lanthanoid oder Titan ist, auf einer Oberfläche eines Substrats unter Verwendung wenigstens eines der hier vorgestellten Metallkomplexe. Außerdem soll ein Verfahren zur Herstellung eines elektronischen Bauelements unter Verwendung wenigstens eines der hier vorgestellten Metallkomplexe zur Verfügung gestellt werden.

Die Aufgabe wird gelöst durch einen Metallkomplex gemäß der allgemeinen Formel

[M(L_{C})(L_{T})(L_{Z})] (I),

wobei
i. M ein Metall-Zentralatom ist, ausgewählt aus der Gruppe bestehend aus Scandium (Sc), Yttrium (Y), Lanthanoiden und Titan (Ti),
ii. Lc ein monoanionischer pi-Donor-Ligand ist, ausgewählt aus der Gruppe bestehend aus
   - unsubstituiertem Cyclopentadienid-Anion (C₅H₅⁻),
   - einfach alkylsubstituierten Cyclopentadienid-Anionen gemäß der allgemeinen Formel R^{A}Cp⁻, wobei R^{A} ausgewählt ist aus der Gruppe bestehend aus linearen Alkylgruppen mit 1 bis 10 Kohlenstoffatomen und verzweigten Alkylgruppen mit 3 bis 10 Kohlenstoffatomen, und
   - mehrfach alkylsubstituierten Cyclopentadienid-Anionen gemäß der allgemeinen Formel R^{B}R^{C}R^{D}R^{E}R^{F}Cp⁻, wobei
      die Reste R^{B}, R^{C}, R^{D}, R^{E} und R^{F} unabhängig voneinander ausgewählt sind aus der Gruppe bestehend aus Wasserstoff (H), linearen Alkylgruppen mit 1 bis 10 Kohlenstoffatomen und verzweigten Alkylgruppen mit 3 bis 10 Kohlenstoffatomen,
      mit der Maßgabe, dass wenigstens zwei der Reste R^{B}, R^{C}, R^{D}, R^{E} und R^{F} ungleich Wasserstoff (H) sind;
iii. L_{T} ein Triazenid-Anion gemäß der allgemeinen Formel (R¹-N₃-R²)⁻ ist, wobei die Reste R¹ und R² unabhängig voneinander ausgewählt sind aus der Gruppe bestehend aus linearen Alkylgruppen mit 1 bis 10 Kohlenstoffatomen und verzweigten Alkylgruppen mit 3 bis 10 Kohlenstoffatomen;
   und
iv. Lz ein
   a) monoanionischer pi-Donor-Ligand ist, welcher unabhängig von dem monoanionischen pi-Donor-Liganden Lc ausgewählt ist aus der Gruppe bestehend aus
      - unsubstituiertem Cyclopentadienid-Anion (C₅H₅⁻),
      - einfach alkylsubstituierten Cyclopentadienid-Anionen gemäß der allgemeinen Formel R^{A}Cp⁻, wobei
         R^{A} ausgewählt ist aus der Gruppe bestehend aus linearen Alkylgruppen mit 1 bis 10 Kohlenstoffatomen und verzweigten Alkylgruppen mit 3 bis 10 Kohlenstoffatomen, und
      - mehrfach alkylsubstituierten Cyclopentadienid-Anionen gemäß der allgemeinen Formel R^{B}R^{C}R^{D}R^{E}R^{F}Cp⁻, wobei die Reste R^{B}, R^{C}, R^{D}, R^{E} und R^{F} unabhängig voneinander ausgewählt sind aus der Gruppe bestehend aus Wasserstoff (H), linearen Alkylgruppen mit 1 bis 10 Kohlenstoffatomen und verzweigten Alkylgruppen mit 3 bis 10 Kohlenstoffatomen,
      mit der Maßgabe, dass wenigstens zwei der Reste R^{B}, R^{C}, R^{D}, R^{E} und R^{F} ungleich Wasserstoff (H) sind;
      oder
   b) Triazenid-Anion gemäß der allgemeinen Formel (R¹-N₃-R²)⁻ ist, wobei die Reste R¹ und R² unabhängig voneinander und unabhängig von dem Triazenid-Anion L_{T} ausgewählt sind aus der Gruppe bestehend aus linearen Alkylgruppen mit 1 bis 10 Kohlenstoffatomen und verzweigten Alkylgruppen mit 3 bis 10 Kohlenstoffatomen.

Dabei umfasst die allgemeine Formel [M(L_{C})(L_{T})(L_{Z})] (I) sowohl einkernige als auch mehrkernige Metallkomplexe.

Im Zusammenhang mit der vorliegenden Erfindung meint der Begriff "Lanthanoide" die Gruppe bestehend aus Lanthan und aus den 14 auf das Lanthan folgenden Elemente der Ordnungszahlen 58 bis 71: Cer (Ce), Praseodym (Pr), Neodym (Nd), Promethium (Pm), Samarium (Sm), Europium (Eu), Gadolinium (Gd), Terbium (Tb), Dysprosium (Dy), Holmium (Ho), Erbium (Er), Thulium (Tm), Ytterbium (Yb) und Lutetium (Lu). Die Lanthanoide werden zusammen mit den leichteren Homologen des Lanthans, also Scandium (Sc) und Yttrium (Y), als "Seltenerdmetalle" bezeichnet.

Es sei darauf hingewiesen, dass in einem Metallkomplex gemäß der allgemeinen Formel [M(L_{C})(L_{T})(L_{Z})] (I), wobei Lz ein monoanionischer pi-Donor-Ligand ist, vorgesehen sein kann, dass der monoanionische pi-Donor-Ligand Lc und der monoanionische pi-Donor-Ligand Lz unterschiedlich oder identisch sind. Und in einem Metallkomplex gemäß der allgemeinen Formel [M(L_{C})(L_{T})(L_{Z})] (I), wobei Lz ein Triazenid-Anion gemäß der allgemeinen Formel (R¹-N₃-R²)⁻ ist, können das Triazenid-Anion L_{T} und das Triazenid-Anion Lz unterschiedlich oder identisch sein.

Der Rest R^{A} kann auch ausgewählt sein aus der Gruppe bestehend aus linearen Alkylgruppen mit 1 bis 9 Kohlenstoffatomen und verzweigten Alkylgruppen mit 3 bis 9 Kohlenstoffatomen, vorteilhafter aus der Gruppe bestehend aus linearen Alkylgruppen mit 1 bis 8 Kohlenstoffatomen und verzweigten Alkylgruppen mit 3 bis 8 Kohlenstoffatomen, noch vorteilhafter aus der Gruppe bestehend aus linearen Alkylgruppen mit 1 bis 7 Kohlenstoffatomen und verzweigten Alkylgruppen mit 3 bis 7 Kohlenstoffatomen, insbesondere aus der Gruppe bestehend aus linearen Alkylgruppen mit 1 bis 6 Kohlenstoffatomen und verzweigten Alkylgruppen mit 3 bis 6 Kohlenstoffatomen.

Bei dem mehrfach alkylsubstituierten Cyclopentadienid-Anion gemäß der allgemeinen Formel R^{B}R^{C}R^{D}R^{E}R^{F}Cp⁻ handelt es sich um ein wenigstens zweifach alkylsubstituiertes Cyclopentadienid-Anion. Es kann sich auch um ein dreifach alkylsubstituiertes oder um ein vierfach alkylsubstituiertes oder um ein fünffach alkylsubstituiertes Cyclopentadienid-Anion handeln. Insbesondere in letzterem Falle ist es vorteilhaft, wenn die Reste R^{B}, R^{C}, R^{D}, R^{E} und R^{F} identisch sind. Dann ist der monoanionische pi-Donor-Ligand im einfachsten Falle das 1,2,3,4,5-Pentamethylcyclopentadienid-Anion, wobei R^{B} = R^{C} = R^{D} = R^{E} = R^{F} = Methyl gilt (C₅Me₅⁻; Cp*).

Die Reste R^{B}, R^{C}, R^{D}, R^{E} und R^{F} können auch unabhängig voneinander ausgewählt sein aus der Gruppe bestehend aus Wasserstoff (H), linearen Alkylgruppen mit 1 bis 9 Kohlenstoffatomen und verzweigten Alkylgruppen mit 3 bis 9 Kohlenstoffatomen, vorteilhafter aus der Gruppe bestehend aus Wasserstoff (H), linearen Alkylgruppen mit 1 bis 8 Kohlenstoffatomen und verzweigten Alkylgruppen mit 3 bis 8 Kohlenstoffatomen, noch vorteilhafter aus der Gruppe bestehend aus Wasserstoff (H), linearen Alkylgruppen mit 1 bis 7 Kohlenstoffatomen und verzweigten Alkylgruppen mit 3 bis 7 Kohlenstoffatomen, insbesondere aus der Gruppe bestehend aus Wasserstoff (H), linearen Alkylgruppen mit 1 bis 6 Kohlenstoffatomen und verzweigten Alkylgruppen mit 3 bis 6 Kohlenstoffatomen, jeweils mit der Maßgabe, dass wenigstens zwei der Reste R^{B}, R^{C}, R^{D}, R^{E} und R^{F} ungleich Wasserstoff (H) sind.

Der Rest R¹ und der Rest R² können auch unabhängig voneinander ausgewählt sein aus der Gruppe bestehend aus linearen Alkylgruppen mit 1 bis 9 Kohlenstoffatomen und verzweigten Alkylgruppen mit 3 bis 9 Kohlenstoffatomen, vorteilhaft aus der Gruppe bestehend aus linearen Alkylgruppen mit 1 bis 8 Kohlenstoffatomen und verzweigten Alkylgruppen mit 3 bis 8 Kohlenstoffatomen, vorteilhafter aus linearen Alkylgruppen mit 1 bis 7 Kohlenstoffatomen und verzweigten Alkylgruppen mit 3 bis 7 Kohlenstoffatomen, noch vorteilhafter aus der Gruppe bestehend aus linearen Alkylgruppen mit 1 bis 6 Kohlenstoffatomen und verzweigten Alkylgruppen mit 3 bis 6 Kohlenstoffatomen.

Die hier vorgestellten Metallkomplexe gemäß Formel I sind vorteilhafterweise reproduzierbar mittels einer einfachen, (atom-)effizienten und vergleichsweise kostengünstig durchführbaren Synthese herstellbar. Und zwar in hoher Reinheit, die den an Präkursormaterialien für chemische Gasphasenabscheidungsverfahren gestellten Anforderungen genügt, und in guter bis sehr guter Ausbeute sowie in guter Raum-Zeit-Ausbeute, und zwar auch im großtechnischen Maßstab. Die Verbindungen gemäß Formel I können grundsätzlich in allen Verfahren der chemischen Gasphasenabscheidung (engl. *Chemical Vapor Deposition,* CVD) eingesetzt werden. Insbesondere handelt es sich um MOCVD-Verfahren, um MOVPE-Verfahren und um ALD-Verfahren.

Die Darstellung der Metallkomplexe des Typs [M(L_{C})(L_{T})(L_{Z})] (I) erfolgt ausgehend von einem wasserfreien Metall(III)-halogenid und einem Alkalimetallcyclopentadienid in einem aprotisch-polaren Lösungsmittel, insbesondere einem Ether, zum Beispiel in THF oder in Et₂O. Das Metall(III)-halogenid, insbesondere ein Metall(III)-chlorid, liegt vorteilhafterweise als - gegebenenfalls *in situ* erzeugtes - THF-Addukt vor.

Mit dem Ausdruck "in situ-Herstellung" bzw. *"in situ*-Erzeugung" ist gemeint, dass die Edukte, welche zur Synthese einer auf diese Weise herzustellenden Verbindung beziehungsweise eines auf diese Art herzustellenden Zwischenproduktes, erforderlich sind, in einer geeigneten Stöchiometrie in einem Lösungsmittel oder Lösungsmittelgemisch zur Reaktion gebracht werden und das dabei entstehende Produkt nicht isoliert wird. Vielmehr wird die Lösung oder die Suspension, welche das *in situ* erzeugte Zwischenprodukt umfasst, direkt weiterverwendet, d. h. ohne Isolierung und/oder weitere Aufreinigung.

Das Produkt der ersten salzmetathetischen Umsetzung, beispielsweise [(EtCp)₂YCl], kann vorteilhafterweise unmittelbar, d. h. ohne Isolierung und/oder Aufreinigung, mit einem Lithium-Triazenid zu dem gewünschten Produkt gemäß Formel I, zum Beispiel [(EtCp)₂Y(*t*Bu-N₃-*t*Bu)], umgesetzt werden. Für diesen Schritt ist es besonders vorteilhaft, ein aprotisch-unpolares Solvens, beispielsweise Toluol, zu wählen. Dann kann das als einziges Nebenprodukt anfallende Lithiumhalogenid, insbesondere LiCl, in einem einfach und rasch durchführbaren Filtrationsschritt und/oder Dekantationsschritt und/oder Zentrifugationsschritt quantitativ oder nahezu quantitativ abgetrennt werden. An die Entfernung des Lösungsmittels schließt sich eine ebenfalls einfach und rasch durchführbare destillative und/oder sublimative Reinigung des Rohproduktes an.

Die Verbindungen gemäß Formel I werden - gemäß ¹H-NMR-spektroskopischer Untersuchung - üblicherweise in einer Reinheit von wenigstens 97%, vorteilhaft von mehr als 97%, insbesondere von mehr als 98% oder 99% erhalten. Dies ist darauf zurückzuführen, dass nach der Isolierung und Aufreinigung des jeweiligen Metallkomplexes gemäß Formel I noch Verunreinigungen durch flüchtige organische Verbindungen enthalten sein können, insbesondere durch im Rahmen der Synthese eingesetzte organische Lösungsmittel. Diese Art von Verunreinigungen ist in Bezug auf die Verwendung der hier beschriebenen Metallkomplexe in chemischen Gasphasenabscheidungsverfahren erfahrungsgemäß unkritisch. Mit anderen Worten: Durch diese Art von Verunreinigungen wird die Qualität der abzuscheidenden Metallschichten oder Metall enthaltenden Schichten üblicherweise nicht beeinträchtigt.

Im Zusammenhang mit der vorliegenden Erfindung beziehen sich der Ausdruck "hohe Reinheit" sowie der Begriff "hochrein" auf einen Gesamtgehalt an Verunreinigungen durch unerwünschte Metalle, unerwünschte Halbmetalle, Luftsauerstoff und Wasser, von unter 1 ppm, idealerweise von unter 100 ppb. In der Halbleiterindustrie wird ein solcher Reinheitsgrad als *electronic grade* bezeichnet. Potenzielle Verunreinigungen der oben beschriebenen Art, d. h. durch flüchtige organische Verbindungen, insbesondere durch im Rahmen der Synthese eingesetzte organische Lösungsmittel, sind bei dieser Reinheitsangabe nicht berücksichtigt.

Die Ausbeute der hier vorgestellten Metallkomplexe gemäß Formel I beträgt in der Regel ≥ 70 %. Bei Durchführung des Verfahrens im industriellen Maßstab werden die Zielverbindungen vorteilhafterweise in vergleichbarer Ausbeute und Reinheit erhalten.

Überraschend ist, dass die hier beschriebenen Metallkomplexe gemäß Formel I nach Durchführung eines einfachen Reinigungsschrittes, nämlich einer Destillation oder einer Sublimation, solvensfrei vorliegen. Mit anderen Worten: Die Metallkomplexe gemäß Formel I, beispielsweise [(EtCp)Sc(*t*Bu-N₃-*t*Bu)₂] und [(EtCp)₂Y(*t*Bu-N₃-*t*Bu)], werden nicht in Form ihrer Lösungsmitteladdukte beziehungsweise Solvensaddukte erhalten. Dies ist in Hinblick auf ihre Verwendung, insbesondere als Präkursoren zur Erzeugung hochreiner Metallschichten oder Metall enthaltender Schichten mittels Verfahren der chemischen Gasphasenabscheidung, besonders vorteilhaft. Überraschend ist die Tatsache, dass die Metallkomplexe gemäß Formel I lösungsmittelfrei vorliegen, vor allem deshalb, weil bei Lanthanoid-Kationen das geringe Verhältnis zwischen Ladung und Radius üblicherweise hohe Koordinationszahlen zur Folge hat. Während zwei Cyclopentadienid-Anionen und ein Amidinat-Anion gemäß der allgemeinen Formel (R^{X}-N-C(R^{Y})=N-R^{Z})⁻ die Koordinationssphäre von Ln(III)-Kationen hinreichend abschirmen können (vgl. US 2014/0335702 A1), ist dies beispielsweise für ein aus zwei Cyclopentadienid-Anionen und einem Triazenid-Anion bestehendes Ligandenregime nicht zu erwarten. Denn ein Triazenid-Anion weist einen - insbesondere im Vergleich zu einem Amidinat-Anion - relativ spitzen Bisswinkel auf.

Die hier vorgestellten Metallkomplexe des Typs [M(L_{C})(L_{T})(L_{Z})] (I) zeichnen sich durch ein heteroleptisches Komplexdesign aus, wobei wenigstens ein Triazenid-Ligand gemäß der allgemeinen Formel (R¹-N₃-R²)⁻ vorgesehen ist. Das Grundgerüst des Triazenid-Liganden weist vorteilhafterweise ausschließlich Stickstoff auf, wobei das Grundgerüst des anionischen N-Donor-Liganden durch die beiden Alkylreste R¹ und R² stabilisiert wird. Aufgrund des stickstoffhaltigen Grundgerüstes wird das im Rahmen eines chemischen Gasphasenabscheidungsverfahrens bestehende Risiko, dass - insbesondere durch Kohlenstoff - verunreinigte und somit qualitativ unbefriedigende Schichten erzeugt werden, deutlich reduziert. Zudem wird der Einbau der gewünschten Elemente, insbesondere der Einbau von Stickstoff, in die zu erzeugenden Schichten gefördert, d. h. die Einbauraten der gewünschten Elemente werden verbessert. Es wurde gefunden, dass dieses Risiko durch die Auswahl der zwei endständigen Alkylgruppen weiter reduziert werden kann. So wurde bei Einsatz des Komplexes [(EtCp)₂Sc(*t*Bu-N₃-*t*Bu)] als Präkursormaterial in einem MOVPE-Verfahren eine noch geringere Kohlenstoffeinbaurate beobachtet als bei Verwendung von Komplexen mit sterisch weniger anspruchsvollen und kohlenstoffärmeren Triazenid-Liganden, wie beispielsweise [(MeCp)₂Sc(R¹-N₃-R²)], wobei R¹ = R² = Me oder Et oder *i*Pr.

Ein weiterer wichtiger Vorteil des hier vorgestellten Komplextypen gemäß der allgemeinen Formel [M(L_{C})(L_{T})(L_{Z})] (I) besteht darin, dass auf sehr einfache Weise eine Vielzahl unterschiedlicher, insbesondere maßgeschneiderter, Präkursoren zur Verfügung gestellt werden kann. Denn zum einen ist das Ligandenregime variabel, d. h. es können entweder a) ein Cyclopentadienid-Ligand Lc, ein Triazenid-Ligand L_{T} und ein Cyclopentadienid-Ligand Lz vorgesehen sein, oder b) ein Cyclopentadienid-Ligand Lc, ein Triazenid-Ligand L_{T} und ein Triazenid-Ligand Lz. Und zum anderen ist jeder der drei Liganden Lc, L_{T} und Lz durch Variation der Reste R^{A}, R^{B}, R^{C}, R^{D}, R^{E}, R^{F}, R¹ und R² in vielfältiger Weise modifizierbar. Dies ist besonders vorteilhaft mit Blick auf die unterschiedlichen Prozessbedingungen, welchen die Präkursormaterialien, beispielsweise in Abhängigkeit von der Wahl des Gasphasenabscheidungsprozesses, ausgesetzt sein können. Es können also mit vergleichsweise geringem Aufwand, nämlich einfach durch Variation des Ligandenregimes und/oder der Substitutionsmuster der drei Liganden L_{C}, L_{T} und Lz, maßgeschneiderte beziehungsweise anwendungsspezifisch optimierte Präkursoren bereitgestellt werden. So kann beispielsweise eine Optimierung für die Anwendung in einem MOCVD-Verfahren oder in einem ALD-Verfahren oder in einem MOVPE-Verfahren erfolgen. In diesem Zusammenhang sei erwähnt, dass der weiter oben skizzierte Syntheseweg vorteilhafterweise im Wesentlichen unabhängig vom gewünschten Metall-Zentralatom sowie vom Ligandenregime beschritten werden kann. Mit anderen Worten: Es können sowohl das Metall-Zentralatom als auch dessen Ligandensphäre, insbesondere durch Modifikation der Substitutionsmuster des/der Cyclopentadienid-Liganden und des/der Triazenid-Liganden, in weiten Bereichen variiert werden, ohne dass wesentliche Änderungen am Syntheseprotokoll vorgenommen werden müssen. Vielmehr bedarf es, wenn überhaupt, lediglich geringfügiger Änderungen des Syntheseprotokolls, beispielsweise in Form eines Lösungsmittelwechsels und/oder einer Temperaturanpassung.

Besonders vorteilhaft ist zudem, dass die hier vorgestellten Metallkomplexe gemäß der Formel I üblicherweise relativ niedrige Schmelztemperaturen aufweisen, in der Regel von weniger als 100 °C oder von weniger als 95 °C oder von weniger als 90 °C, beispielsweise von ca. 80 °C im Falle von [(MeCp)₂Sc(*t*Bu-N₃-*t*Bu)] oder von ca. 40 °C im Falle von [(EtCp)₂Y(*t*Bu-N₃-*t*Bu)]. Hinzu kommt, dass Metallkomplexe zur Verfügung gestellt werden können, welche Molekulargewichte von weniger als 600 g/mol aufweisen, vorteilhaft von höchstens 595 g/mol, insbesondere von weniger als 595 g/mol. Komplexe gemäß Formel I, wobei M = Sc, Y oder Ti ist, können beispielsweise auch Molekulargewichte von weniger als 550 g/mol oder von weniger als 500 g/mol besitzen, beispielsweise im Bereich von 350 g/mol bis 550 g/mol. Daraus ergibt sich - in Verbindung mit einer niedrigen Schmelztemperatur - für die hier beschriebenen Metallkomplexe vorteilhafterweise ein relativ hoher Dampfdruck.

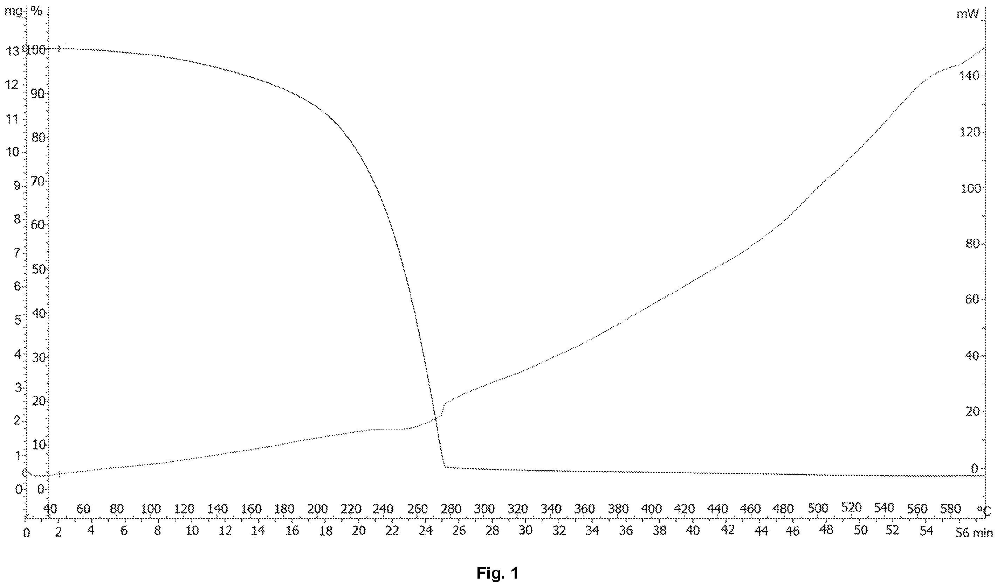

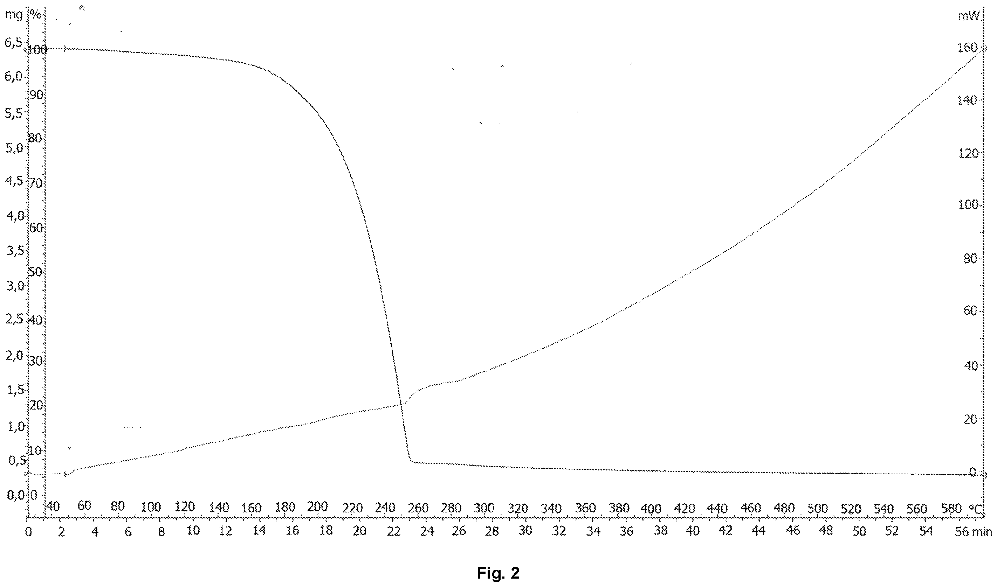

Die thermogravimetrische Analyse (TGA) ausgewählter Metallkomplexe gemäß Formel I, insbesondere der Komplexe [(EtCp)₂Sc(*t*Bu-N₃-*t*Bu)] und [(EtCp)Sc(*t*Bu-N₃-*t*Bu)₂] (vgl. **Fig. 1** und **Fig. 2****),** hatte zum Ergebnis, dass der Übergang dieser Präkursorverbindungen in die Gasphase bei relativ geringen Temperaturen erfolgt. Besonders vorteilhaft ist, dass dieser Übergang zudem zersetzungsfrei stattfindet. Folglich kann bei Verwendung eines Komplexes des hier vorgestellten Typs als Präkursor in einem Verfahren der chemischen Gasphasenabscheidung vorteilhafterweise eine gezielte Zersetzung des jeweiligen Präkursors durchgeführt werden, und zwar bei relativ geringen Prozesstemperaturen. Insgesamt wird somit eine bessere Verfügbarkeit der Präkursoren in der Gasphase erreicht und letztlich eine Steigerung der Einbaurate der gewünschten Elemente. Hinzu kommt, dass die gezielte Zersetzung bei vergleichsweise geringen Prozesstemperaturen sich positiv auf das Schichtwachstum auswirkt. Mithin sind die erzeugten Schichten hinsichtlich ihrer Reinheit, ihrer Zusammensetzung und ihrer Morphologie qualitativ hochwertig.

Der Ausdruck "qualitativ hochwertige Schicht" bezieht sich im Zusammenhang mit der vorliegenden Erfindung auf die Reinheit, die Zusammensetzung, insbesondere auf den Gehalt des jeweiligen Metalls M, und die Morphologie einer mittels eines Verfahrens der chemischen Gasphasenabscheidung erzeugten Schicht.

Beispielhaft wurde der Komplex [(EtCp)₂Sc(*t*Bu-N₃-*t*Bu)] als Präkursormaterial in einem MOVPE-Verfahren zur Erzeugung von AlScN-Schichten eingesetzt. Die AlScN-Schichten wurden beispielsweise auf einer Oberfläche eines Galliumnitrid-Substrats (GaN-Substrats) abgeschieden. Die Wachstumstemperatur lag üblicherweise im Bereich von 900 °C bis 1.200 °C, die Innentemperatur des *Bubblers,* auf Deutsch auch als Dampfdrucksättiger bezeichnet, betrug in der Regel ca. 50 °C bis ca. 100 °C. Überraschenderweise wurde auch bei einer relativ niedrigen Innentemperatur des *Bubblers* im vorgenannten Bereich ein ausreichend hoher Dampfdruck des Präkursors beobachtet. Eine molare Strömung im üblicherweise gewählten Bereich wurde erreicht, indem ein Wasserstoffstrom (Trägergas) eingestellt wurde, welcher mit dem für den Präkursor ermittelten Strom vergleichbar war. Es wurden Schichtwachstumsraten im erwarteten Bereich erzielt. In Abhängigkeit von den jeweils gewählten Wachstumsbedingungen, insbesondere von dem gewählten Substrat, der Innentemperatur des *Bubblers* und der Prozesstemperatur, enthielten die erzeugten AlScN-Schichten wenigstens ca. 10 Atomprozent Scandium, d. h. die Scandium-Einbaurate betrug wenigstens ca. 10 Atomprozent. Mithin war der Scandiumgehalt mindestens vergleichbar mit dem Wert von ≈ 10%, welcher kürzlich von Streicher et al. (Phys. Status Solidi RRL 2023, 17, 2200387) für eine AlScN-Schicht berichtet wurde. Diese Schicht wurde mittels eines MOCVD-Verfahrens unter Verwendung von Bis(methylcyclopentadienyl)scandiumchlorid ([(MeCp)₂ScCl]₂) erhalten, und zwar bei einer Wachstumstemperatur von 900 °C.

Überraschenderweise wurde bei Einsatz des hier vorgestellten Komplexes [(EtCp)₂Sc(*t*Bu-N₃-*t*Bu)] - anders als im Falle des von den Erfindern unter identischen Prozessbedingungen ebenfalls eingesetzten vorbekannten Präkursors [(MeCp)₂ScCl]₂ - gefunden, dass die Scandium-Einbaurate nicht von der Wachstumstemperatur abhängig ist.

Die prozentuale atomare Zusammensetzung der im Zusammenhang mit dieser Erfindung erzeugten AlScN-Schichten wurde jeweils mittels hochauflösender Transmissionselektronenmikroskopie (engl. *high resolution transmission electron microscopy,* HRTEM) in Kombination mit energiedispersiver Röntgenanalyse (engl. *energy dispersive X-ray analysis,* EDXA) an einem Rastertransmissionselektronenmikroskop (engl. *scanning transmission electron microscope, STEM*) bestimmt.

Zusammenfassend lässt sich feststellen, dass die hier vorgestellten Metallkomplexe gemäß der allgemeinen Formel [M(L_{C})(L_{T})(L_{Z})] (I) auf einfache Weise hochrein in guten bis sehr guten Ausbeuten, auch im industriellen Maßstab, herstellbar sind. Das heteroleptische, variable Komplexdesign, welches wenigstens einen Liganden mit einem stickstoffbasierten, kohlenstofffreien Grundgerüst (Triazenid-Ligand) vorsieht, ermöglicht die Bereitstellung einer Vielzahl unterschiedlicher Metallkomplexe, welche vorteilhaft maßgeschneidert beziehungsweise anwendungsspezifisch optimiert sind. Besonders vorteilhaft ist, dass die hier beschriebenen Metallkomplexe des Typs [M(L_{C})(L_{T})(L_{Z})] (I) sämtlichen an Präkursormaterialien für chemische Gasphasenabscheidungsverfahren gestellten Anforderungen genügen und somit insbesondere für den Einsatz in Verfahren dieser Art prädestiniert sind. Besonders vorteilhaft ist, dass das Komplexdesign der Verbindungen gemäß Formel I sowohl die Förderung des Einbaus gewünschter Elemente in die zu erzeugende Schicht als auch die Reduzierung des Einbaus unerwünschter Elemente, wie beispielsweise Kohlenstoff, bedingt. Vorteilhafterweise kann die Verwendung dieser Komplexe unter idealen Prozesstemperaturen erfolgen, sodass qualitativ hochwertige Metallschichten und Metall enthaltende Schichten erzeugt werden können. Beispielsweise Schichten, welche einen Lanthanoid enthaltenden III-V-Verbindungshalbleiter oder ein Ln-Oxid umfassen oder daraus bestehen. Insgesamt ist der Einsatz von Komplexen des hier vorgestellten Typs in chemischen Gasphasenabscheidungsverfahren aus (atom-)ökonomischer und ökologischer Sicht besonders vorteilhaft.

In einer vorteilhaften Ausführungsform des hier beschriebenen Metallkomplexes ist das Lanthanoid ausgewählt aus der Gruppe bestehend aus
i. La, Ce, Pr, Nd, Sm, Eu, Gd, Tb, Dy, Ho, Er, Tm, Yb und Lu;
   oder
ii. La, Ce, Pr, Nd, Sm, Eu, Gd, Tb, Er, Yb und Lu;
   oder
iii. La, Ce, Pr, Nd, Eu, Gd, Er, Yb und Lu.

Insbesondere ist das Lanthanoid ausgewählt aus der Gruppe bestehend aus La, Ce, Nd, Eu, Er und Lu.

Gemäß einer anderen Ausführungsvariante des hier vorgestellten Metallkomplexes ist vorgesehen, dass
i. der monoanionische pi-Donor-Ligand Lc ausgewählt ist aus der Gruppe bestehend aus
   - unsubstituiertem Cyclopentadienid-Anion (C₅H₅⁻);
   - einfach alkylsubstituierten Cyclopentadienid-Anionen gemäß der allgemeinen Formel R^{A}Cp⁻, wobei
      der Rest R^{A} ausgewählt ist aus der Gruppe bestehend aus Methyl, Ethyl, Propyl, Butyl, Pentyl, und deren Isomeren, insbesondere aus der Gruppe bestehend aus Methyl, Ethyl, *n*-Propyl, *iso*-Propyl, *n*-Butyl, *iso*-Butyl, *sec-*Butyl und *tert*-Butyl;
   - mehrfach alkylsubstituierten Cyclopentadienid-Anionen gemäß der allgemeinen Formel R^{B}R^{C}R^{D}R^{E}R^{F}Cp⁻, wobei
      die Reste R^{B}, R^{C}, R^{D}, R^{E} und R^{F} unabhängig voneinander ausgewählt sind aus der Gruppe bestehend aus Wasserstoff (H), Methyl, Ethyl, Propyl, Butyl, Pentyl, und deren Isomeren, insbesondere aus der Gruppe bestehend aus Wasserstoff (H), Methyl, Ethyl, *n*-Propyl, *iso*-Propyl, *n*-Butyl, *iso*-Butyl, *sec*-Butyl und *tert*-Butyl,
      mit der Maßgabe, dass wenigstens zwei der Reste R^{B}, R^{C}, R^{D}, R^{E} und R^{F} ungleich Wasserstoff (H) sind;
      und/oder
ii. wenigstens einer der Reste R¹ und R² des Triazenid-Anions L_{T} ausgewählt ist aus der Gruppe bestehend aus linearen Alkylgruppen mit 1 bis 6 Kohlenstoffatomen und verzweigten Alkylgruppen mit 3 bis 6 Kohlenstoffatomen.

Es kann auch vorgesehen sein, dass der monoanionische pi-Donor-Ligand Lc ein mehrfach alkylsubstituiertes Cyclopentadienid-Anion gemäß der allgemeinen Formel R^{B}R^{C}R^{D}R^{E}R^{F}Cp⁻ ist, wobei die Reste R^{B}, R^{C}, R^{D}, R^{E} und R^{F} unabhängig voneinander ausgewählt sind aus der Gruppe bestehend aus Wasserstoff (H), Methyl, Ethyl, Propyl, Butyl, Pentyl, und deren Isomeren, insbesondere aus der Gruppe bestehend aus Wasserstoff (H), Methyl, Ethyl, *n*-Propyl, *iso*-Propyl, *n*-Butyl, *iso*-Butyl, *sec*-Butyl und *tert*-Butyl, mit der Maßgabe, dass wenigstens zwei der Reste R^{B}, R^{C}, R^{D}, R^{E} und R^{F}, welche ungleich Wasserstoff (H) sind, identisch sind.

Dann handelt es sich bei dem pi-Donor-Liganden Lc zum Beispiel um Me₄Cp⁻ oder um Me(Et)₂Cp⁻ oder um Et₂Cp⁻ oder um Et₂(*i*Bu)Cp⁻ oder um Me₅Cp⁻ (Cp*).

Außerdem kann vorgesehen sein, dass der monoanionische pi-Donor-Ligand Lc ein mehrfach alkylsubstituiertes Cyclopentadienid-Anionen gemäß der allgemeinen Formel R^{B}R^{C}R^{D}R^{E}R^{F}Cp⁻ ist, wobei die Reste R^{B}, R^{C}, R^{D}, R^{E} und R^{F} unabhängig voneinander ausgewählt sind aus der Gruppe bestehend aus Wasserstoff (H), Methyl, Ethyl, Propyl, Butyl, Pentyl, und deren Isomeren, insbesondere aus der Gruppe bestehend aus Wasserstoff (H), Methyl, Ethyl, *n-*Propyl, *iso*-Propyl, *n*-Butyl, *iso*-Butyl, *sec*-Butyl und *tert*-Butyl, mit der Maßgabe, dass genau zwei oder genau drei oder genau vier oder genau fünf der Reste R^{B}, R^{C}, R^{D}, R^{E} und R^{F} ungleich Wasserstoff (H) sind, vorteilhaft genau zwei oder genau fünf der Reste R^{B}, R^{C}, R^{D}, R^{E} und R^{F} ungleich Wasserstoff (H) sind.

Dann handelt es sich bei dem pi-Donor-Liganden Lc zum Beispiel um ein Anion ausgewählt aus der Gruppe bestehend aus Me₂Cp⁻, Me(Et)Cp⁻, Et₂Cp⁻, Me(*i*Pr)Cp⁻, Et(*i*Pr)Cp⁻, *i*Pr₂Cp⁻, Me(*i*Bu)Cp⁻, Et(*i*Bu)Cp⁻, *i*Bu₂Cp⁻, Me(*s*Bu)Cp⁻, Et(*s*Bu)Cp⁻ und *s*Bu₂Cp⁻. Alternativ kann es sich bei dem pi-Donor-Liganden Lc zum Beispiel um Me₄Cp⁻ oder um Me(Et)₂Cp⁻ oder um Et₂(*i*Bu)Cp⁻ oder um Me₅Cp⁻ (Cp*) handeln.

Nach einer weiteren vorteilhaften Ausführungsvariante des hier vorgestellten Metallkomplexes ist vorgesehen, dass der Ligand Lz ein monoanionischer pi-Donor-Ligand ist, wobei
i. der monoanionische pi-Donor-Ligand Lc oder der monoanionische pi-Donor-Ligand Lz ausgewählt ist
   oder
ii. der monoanionische pi-Donor-Ligand Lc und der monoanionische pi-Donor-Ligand Lz unabhängig voneinander ausgewählt sind
   aus der Gruppe bestehend aus
   - unsubstituiertem Cyclopentadienid-Anion (C₅H₅⁻);
   - einfach alkylsubstituierten Cyclopentadienid-Anionen gemäß der allgemeinen Formel R^{A}Cp⁻, wobei der Rest R^{A} ausgewählt ist aus der Gruppe bestehend aus Methyl, Ethyl, Propyl, Butyl, Pentyl, und deren Isomeren, insbesondere aus der Gruppe bestehend aus Methyl, Ethyl, *n*-Propyl, *iso*-Propyl, *n*-Butyl, *iso*-Butyl, *sec*-Butyl und *tert*-Butyl;

- mehrfach alkylsubstituierten Cyclopentadienid-Anionen gemäß der allgemeinen Formel R^{B}R^{C}R^{D}R^{E}R^{F}Cp⁻, wobei
   die Reste R^{B}, R^{C}, R^{D}, R^{E} und R^{F} unabhängig voneinander ausgewählt sind aus der Gruppe bestehend aus Wasserstoff (H), Methyl, Ethyl, Propyl, Butyl, Pentyl, und deren Isomeren, insbesondere aus der Gruppe bestehend aus Wasserstoff (H), Methyl, Ethyl, *n*-Propyl, *iso*-Propyl, *n*-Butyl, *iso*-Butyl, *sec-*Butyl und *tert*-Butyl,
   mit der Maßgabe, dass wenigstens zwei der Reste R^{B}, R^{C}, R^{D}, R^{E} und R^{F} ungleich Wasserstoff (H) sind.

In einer alternativen oder ergänzenden Ausführungsform ist wenigstens einer der Reste R¹ und R² des Triazenid-Anions L_{T} ausgewählt aus der Gruppe bestehend aus linearen Alkylgruppen mit 1 bis 6 Kohlenstoffatomen und verzweigten Alkylgruppen mit 3 bis 6 Kohlenstoffatomen.

Gemäß einer weiteren Ausführungsform des hier vorgestellten Metallkomplexes sind der Rest R¹ und der Rest R² des Triazenid-Anions L_{T} unabhängig voneinander ausgewählt aus der Gruppe bestehend aus Methyl, Ethyl, Propyl, Butyl, Pentyl, und deren Isomeren, insbesondere aus der Gruppe bestehend aus Methyl, Ethyl, iso-Propyl, *iso*-Butyl, *sec*-Butyl und *tert*-Butyl.

Ist der Ligand Lz ein monoanionischer pi-Donor-Ligand, so kann auch vorgesehen sein, dass
i. der monoanionische pi-Donor-Ligand Lc oder der monoanionische pi-Donor-Ligand Lz ausgewählt ist
   oder
ii. der monoanionische pi-Donor-Ligand Lc und der monoanionische pi-Donor-Ligand Lz unabhängig voneinander ausgewählt sind

aus der Gruppe bestehend aus mehrfach alkylsubstituierten Cyclopentadienid-Anionen gemäß der allgemeinen Formel R^{B}R^{C}R^{D}R^{E}R^{F}Cp⁻, wobei die Reste R^{B}, R^{C}, R^{D}, R^{E} und R^{F} unabhängig voneinander ausgewählt sind aus der Gruppe bestehend aus Wasserstoff (H), Methyl, Ethyl, Propyl, Butyl, Pentyl, und deren Isomeren, insbesondere aus der Gruppe bestehend aus Wasserstoff (H), Methyl, Ethyl, *n*-Propyl, *iso*-Propyl, *n*-Butyl, *iso*-Butyl, *sec*-Butyl und *tert*-Butyl,
mit der Maßgabe, dass wenigstens zwei der Reste R^{B}, R^{C}, R^{D}, R^{E} und R^{F}, welche ungleich Wasserstoff (H) sind, identisch sind.

Dann ist der pi-Donor-Ligand Lc und/oder der pi-Donor-Ligand Lz zum Beispiel ausgewählt aus der Gruppe bestehend aus Me₄Cp⁻, Me(Et)₂Cp⁻, Et₂Cp⁻, Et₂(*i*Bu)Cp⁻ und Me₅Cp⁻ (Cp*).

Außerdem kann vorgesehen sein, dass
i. der monoanionische pi-Donor-Ligand Lc oder der monoanionische pi-Donor-Ligand Lz ausgewählt ist
   oder
ii. der monoanionische pi-Donor-Ligand Lc und der monoanionische pi-Donor-Ligand Lz unabhängig voneinander ausgewählt sind
aus der Gruppe bestehend aus mehrfach alkylsubstituierten Cyclopentadienid-Anionen gemäß der allgemeinen Formel R^{B}R^{C}R^{D}R^{E}R^{F}Cp⁻, wobei die Reste R^{B}, R^{C}, R^{D}, R^{E} und R^{F} unabhängig voneinander ausgewählt sind aus der Gruppe bestehend aus Wasserstoff (H), Methyl, Ethyl, Propyl, Butyl, Pentyl, und deren Isomeren, insbesondere aus der Gruppe bestehend aus Wasserstoff (H), Methyl, Ethyl, *n*-Propyl, *iso*-Propyl, *n*-Butyl, *iso*-Butyl, *sec*-Butyl und *tert*-Butyl, mit der Maßgabe, dass genau zwei oder genau drei oder genau vier oder genau fünf der Reste R^{B}, R^{C}, R^{D}, R^{E} und R^{F} ungleich Wasserstoff (H) sind, vorteilhaft genau zwei oder genau fünf der Reste R^{B}, R^{C}, R^{D}, R^{E} und R^{F} ungleich Wasserstoff (H) sind.

Dann ist der pi-Donor-Ligand Lc und/oder der pi-Donor-Ligand Lz zum Beispiel ausgewählt aus der Gruppe bestehend aus Me₂Cp⁻, Me(Et)Cp⁻, Et₂Cp⁻, Me(*i*Pr)Cp⁻, Et(*i*Pr)Cp⁻, *i*Pr₂Cp⁻, Me(*i*Bu)Cp⁻, Et(*i*Bu)Cp⁻, *i*Bu₂Cp⁻, Me(*s*Bu)Cp⁻, Et(*s*Bu)Cp⁻ und *s*Bu₂Cp⁻. Alternativ kann es sich bei dem pi-Donor-Liganden Lc und/oder dem pi-Donor-Liganden Lz zum Beispiel um Me₄Cp⁻ oder um Me(Et)₂Cp⁻ oder um Et₂(*i*Bu)Cp⁻ oder um Me₅Cp⁻ (Cp*) handeln.

In einer noch anderen Variante des hier beschriebenen Metallkomplexes ist vorgesehen, dass Lz ein monoanionischer pi-Donor-Ligand ist, wobei der monoanionische pi-Donor-Ligand Lc und der monoanionische pi-Donor-Ligand Lz identisch sind.

Gemäß einer weiteren vorteilhaften Ausführungsform des hier vorgestellten Metallkomplexes ist der Ligand Lz ein Triazenid-Anion gemäß der allgemeinen Formel (R¹-N₃-R²)⁻ ist, wobei wenigstens einer der Reste R¹ und R² des Triazenid-Anions Lz ausgewählt ist aus der Gruppe bestehend aus linearen Alkylgruppen mit 1 bis 6 Kohlenstoffatomen und verzweigten Alkylgruppen mit 3 bis 6 Kohlenstoffatomen.

Eine andere vorteilhafte Ausführungsform sieht vor, dass der Ligand Lz ein Triazenid-Anion gemäß der allgemeinen Formel (R¹-N₃-R²)⁻ ist, wobei der Rest R¹ und der Rest R² des Triazenid-Anions Lz unabhängig voneinander und unabhängig von dem Triazenid-Anion L_{T} ausgewählt sind aus der Gruppe bestehend aus Methyl, Ethyl, Propyl, Butyl, Pentyl, und deren Isomeren, insbesondere aus der Gruppe bestehend aus Methyl, Ethyl, *iso*-Propyl, *iso*-Butyl, *sec*-Butyl und *tert*-Butyl.

In einer weiteren Variante des hier vorgestellten Metallkomplexes ist Lz ein Triazenid-Anion gemäß der allgemeinen Formel (R¹-N₃-R²)⁻, wobei das Triazenid-Anion L_{T} und das Triazenid-Anion Lz identisch sind.

Gemäß einer noch anderen Ausführungsvariante des hier vorgestellten Metallkomplexes ist vorgesehen, dass
i. der Rest R¹ und der Rest R² des Triazenid-Anions L_{T} identisch sind, und/oder
ii. Lz ein Triazenid-Anion gemäß der allgemeinen Formel (R¹-N₃-R²)⁻ ist, wobei der Rest R¹ und der Rest R² des Triazenid-Anions Lz identisch sind.

Eine noch andere vorteilhafte Ausführungsform des hier beschriebenen Metallkomplexes sieht vor, dass das das Metall-Zentralatom M ausgewählt ist aus der Gruppe bestehend aus Sc, Y, La, Ce, Nd, Eu, Er, Lu und Ti, und
A. der Ligand Lz ein monoanionischer pi-Donor-Ligand ist, wobei
   i. der monoanionische pi-Donor-Ligand Lc oder der monoanionische pi-Donor-Ligand Lz ausgewählt ist
      oder
   ii. der monoanionische pi-Donor-Ligand Lc und der monoanionische pi-Donor-Ligand Lz unabhängig voneinander ausgewählt sind

   aus der Gruppe bestehend aus
      - unsubstituiertem Cyclopentadienid-Anion (C₅H₅⁻);
      - einfach alkylsubstituierten Cyclopentadienid-Anionen gemäß der allgemeinen Formel R^{A}Cp⁻, wobei der Rest R^{A} ausgewählt ist aus der Gruppe bestehend aus Methyl, Ethyl, *n*-Propyl, *iso*-Propyl, *n*-Butyl, *iso-*Butyl, *sec*-Butyl und *tert*-Butyl;
      - mehrfach alkylsubstituierten Cyclopentadienid-Anionen gemäß der allgemeinen Formel R^{B}R^{C}R^{D}R^{E}R^{F}Cp⁻, wobei
         die Reste R^{B}, R^{C}, R^{D}, R^{E} und R^{F} unabhängig voneinander ausgewählt sind aus der Gruppe bestehend aus Wasserstoff (H), Methyl, Ethyl, *n*-Propyl, *iso*-Propyl, *n*-Butyl, *iso*-Butyl, *sec*-Butyl und *tert*-Butyl,
         mit der Maßgabe, dass wenigstens zwei der Reste R^{B}, R^{C}, R^{D}, R^{E} und R^{F}, welche ungleich Wasserstoff (H) sind, identisch sind;
      und
   der Rest R¹ und der Rest R² des Triazenid-Anions L_{T} unabhängig voneinander ausgewählt sind aus der Gruppe bestehend aus Methyl, Ethyl, *iso*-Propyl, *iso*-Butyl, *sec*-Butyl und *tert*-Butyl;
   oder
B. der Ligand Lz ein Triazenid-Anion gemäß der allgemeinen Formel (R¹-N₃-R²)- ist, wobei
   i. die Reste R¹ und R² eines der beiden Triazenid-Anionen L_{T} und Lz unabhängig voneinander ausgewählt sind aus der Gruppe bestehend aus Methyl, Ethyl, *iso*-Propyl, *iso*-Butyl, *sec*-Butyl und *tert*-Butyl,
      oder
   ii. die Reste R¹ und R² des Triazenid-Anions L_{T} und die Reste R¹ und R² des Triazenid-Anions Lz jeweils unabhängig voneinander ausgewählt sind aus der Gruppe bestehend aus Methyl, Ethyl, *iso*-Propyl, *iso*-Butyl, *sec*-Butyl und *tert*-Butyl;
   und
   der monoanionische pi-Donor-Ligand Lc ausgewählt ist aus der Gruppe bestehend aus
   - unsubstituiertem Cyclopentadienid-Anion (C₅H₅⁻);
   - einfach alkylsubstituierten Cyclopentadienid-Anionen gemäß der allgemeinen Formel R^{A}Cp⁻, wobei
      der Rest R^{A} ausgewählt ist aus der Gruppe bestehend aus Methyl, Ethyl, *n*-Propyl, *iso*-Propyl, *n*-Butyl, *iso*-Butyl, *sec*-Butyl und *tert*-Butyl;
   - mehrfach alkylsubstituierten Cyclopentadienid-Anionen gemäß der allgemeinen Formel R^{B}R^{C}R^{D}R^{E}R^{F}Cp⁻, wobei
      die Reste R^{B}, R^{C}, R^{D}, R^{E} und R^{F} unabhängig voneinander ausgewählt sind aus der Gruppe bestehend aus Wasserstoff (H), Methyl, Ethyl, *n-*Propyl, *iso*-Propyl, *n*-Butyl, *iso*-Butyl, *sec*-Butyl und *tert*-Butyl,
      mit der Maßgabe, dass wenigstens zwei der Reste R^{B}, R^{C}, R^{D}, R^{E} und R^{F}, welche ungleich Wasserstoff (H) sind, identisch sind.

Gemäß Variante A. kann beispielsweise vorgesehen sein, dass der pi-Donor-Ligand Lc und/oder der pi-Donor-Ligand Lz ausgewählt ist aus der Gruppe bestehend aus Cp⁻ (C₅H₅⁻), MeCp⁻ (MeC₅H₄⁻), EtCp⁻ (EtC₅H₄⁻), *i*PrCp⁻ (*i*PrC₅H₄⁻), *i*BuCp⁻ (*i*BuC₅H₄⁻), *s*BuCp⁻ (*s*BuC₅H₄⁻), *t*BuCp⁻ (*t*BuC₅H₄⁻), Et₂Cp⁻ (Et₂C₅H₃⁻) und Me₅Cp⁻ (Cp*, C₅Me₅⁻). Und der Triazenid-Ligand L_{T} kann zum Beispiel ausgewählt sein aus der Gruppe bestehend aus (Me-N₃-Me)⁻, (*i*Pr-N₃-*i*Pr)⁻, (*i*Pr-N₃-*t*Bu)⁻, (*t*Bu-N₃-*t*Bu)⁻ und (*i*Bu-N₃-*i*Bu)⁻.

Gemäß Variante B. können der Triazenid-Ligand L_{T} und/oder der Triazenid-Ligand Lz beispielsweise ausgewählt sein aus der Gruppe bestehend aus (Me-N₃-Me)⁻, (*i*Pr-N₃-*i*Pr)⁻, (*i*Pr-N₃-*t*Bu)⁻, (*t*Bu-N₃-*t*Bu)⁻ und (*i*Bu-N₃-*i*Bu)⁻. Und der monoanionische pi-Donor-Ligand Lc ist zum Beispiel ausgewählt aus der Gruppe bestehend aus Cp⁻ (C₅H₅⁻), MeCp⁻ (MeC₅H₄⁻), EtCp⁻ (EtC₅H₄⁻), *i*PrCp⁻ (*i*PrC₅H₄⁻), *i*BuCp⁻ (*i*BuC₅H₄⁻), *s*BuCp⁻ (*s*BuC₅H₄⁻), *t*BuCp⁻ (*t*BuC₅H₄⁻), Et₂Cp⁻ (Et₂C₅H₃⁻), und Me₅Cp⁻ (Cp*, C₅Me₅⁻).

Nach einer weiteren Ausführungsform des hier beschriebenen Metallkomplexes weist der Metallkomplex die Formel I.1 oder die Formel I.2 oder die Formel I.3 oder die Formel I.4 oder die Formel I.5 oder die Formel I.6 oder die Formel I.7 oder die Formel I.8 oder die Formel I.9 oder die Formel I.10 oder die Formel I.11 auf:

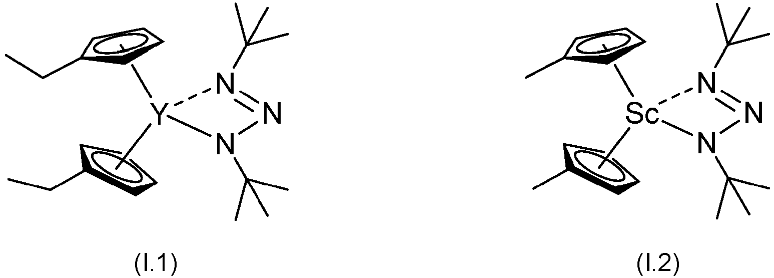

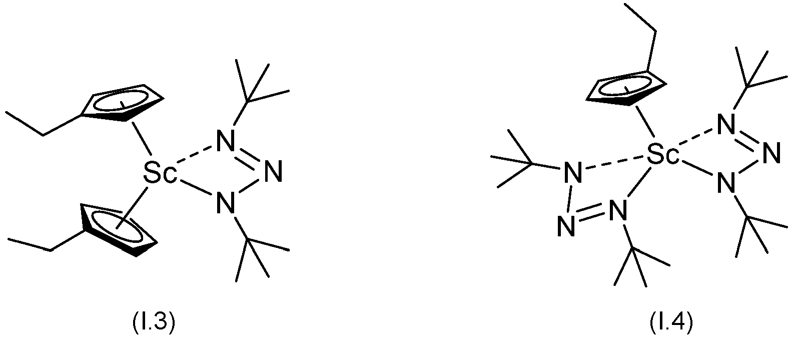

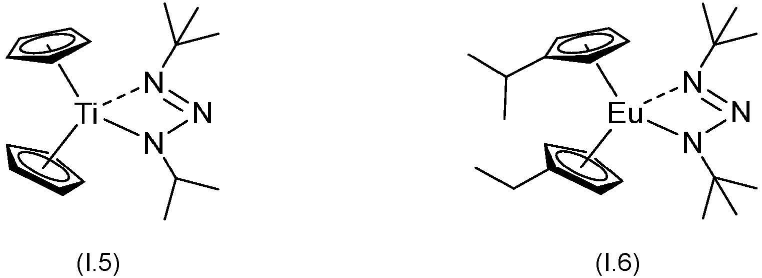

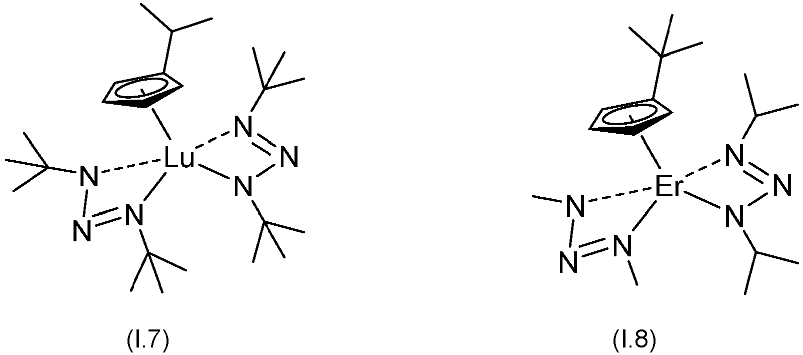

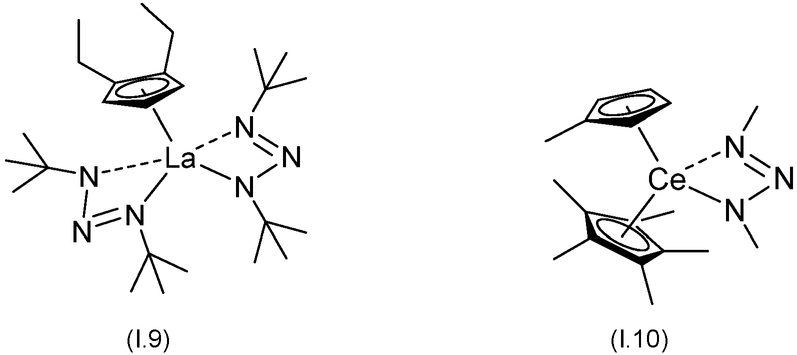

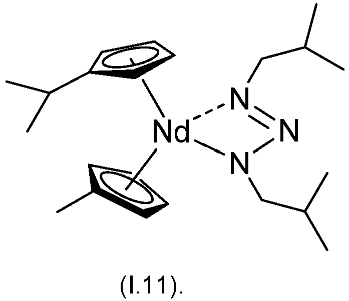

Gemäß einer anderen vorteilhaften Ausführungsform des hier beschriebenen Metallkomplexes ist der Metallkomplex zersetzungsfrei verdampfbar oder zersetzungsfrei sublimierbar.

Dies ist besonders vorteilhaft, zumal infolge des zersetzungsfreien Übergangs des Metallkomplexes in die Gasphase die Einbaurate des jeweiligen Metalls M erhöht wird. Auch die Einbaurate von Stickstoff wird erhöht. Die erzeugten Schichten sind hinsichtlich ihrer Reinheit, ihrer Zusammensetzung und ihrer Morphologie qualitativ hochwertig. Insgesamt wird durch diese Eigenschaft des Metallkomplexes die (atom-)ökonomische und ökologische Verfahrensbilanz besonders positiv beeinflusst. Für weitere Details bezüglich der Vorteile des zersetzungsfreien Übergangs einer Präkursorverbindung in die Gasphase wird auf die diesbezüglich weiter oben gemachten Angaben verwiesen.

Nach einer weiteren vorteilhaften alternativen oder ergänzenden Variante beträgt ein Molekulargewicht des Metallkomplexes weniger als 600 g/mol, vorteilhaft höchstens 595 g/mol, insbesondere weniger als 595 g/mol.

Im Vergleich dazu weisen zwei in WO 2019/115646 beschriebene homoleptische Ln(III)-triazenidkomplexe (Ln = La oder Ce) jeweils ein Molekulargewicht von mehr als 600 g/mol (ca. 608 g/mol) auf.

Das in der Regel vergleichsweise geringe Molekulargewicht des hier beschriebenen Metallkomplexes gemäß Formel I, vorteilhaft von höchstens 595 g/mol, insbesondere von weniger als 595 g/mol, ermöglicht vorteilhafterweise eine besonders (energie-)effiziente Überführung des Metallkomplexes in die Gasphase.

Metallkomplexe gemäß Formel I, wobei M = Sc, Y oder Ti ist, können Molekulargewichte von weniger als 550 g/mol oder von weniger als 500 g/mol besitzen, beispielsweise im Bereich von 350 g/mol bis 550 g/mol. So beträgt das Molekulargewicht im Falle der weiter oben gezeigten Y(III)-Verbindung gemäß Formel I.1 zwischen 400 g/mol und 450 g/mol, nämlich ca. 431 g/mol, und im Falle des weiter oben dargestellten Sc(III)-Komplexes gemäß Formel I.2 zwischen 350 g/mol und 400 g/mol, nämlich ca. 360 g/mol.

Die Aufgabe wird außerdem gelöst durch ein Verfahren zur Herstellung einer Schicht, welche
i. aus wenigstens einem Metall M besteht,
   wobei das wenigstens eine Metall M ausgewählt ist aus der Gruppe bestehend aus Scandium, Yttrium, Lanthanoiden und Titan,
   oder
ii. wenigstens ein Metall M enthält,
   wobei das wenigstens eine Metall M ausgewählt ist aus der Gruppe bestehend aus Scandium, Yttrium, Lanthanoiden und Titan,
auf einer Oberfläche eines Substrats, insbesondere eines Halbleitersubstrats, unter Verwendung
- wenigstens eines Metallkomplexes gemäß der allgemeinen Formel [M(L_{C})(L_{T})(L_{Z})] (I) nach einer oder mehreren der weiter oben beschriebenen Ausführungsformen,
   oder
- einer Lösung, umfassend wenigstens einen Metallkomplex gemäß der allgemeinen Formel [M(L_{C})(L_{T})(L_{Z})] (I) nach einer oder mehreren der weiter oben beschriebenen Ausführungsformen und ein aprotisch-unpolares Lösungsmittel.

Dabei umfasst das Verfahren die folgenden Schritte:
A. Zurverfügungstellung
   - des wenigstens einen Metallkomplexes nach einer oder mehreren der weiter oben beschriebenen Ausführungsformen,
      oder
   - der Lösung, umfassend wenigstens einen Metallkomplex nach einer oder mehreren der weiter oben beschriebenen Ausführungsformen und ein aprotisch-unpolares Lösungsmittel,
   und
B. Abscheidung der Schicht, welche
   i. aus dem wenigstens einen Metall M besteht,
      oder
   ii. das wenigstens eine Metall M enthält,
   auf der Oberfläche des Substrats unter Verwendung des in Schritt A. zur Verfügung gestellten wenigstens einen Metallkomplexes als Präkursorverbindung.

Der in Schritt A. zur Verfügung zu stellende wenigstens eine Metallkomplex des weiter oben beschriebenen Typs [M(L_{C})(L_{T})(L_{Z})] (I) oder die zur Verfügung zu stellende Lösung, umfassend wenigstens einen Metallkomplex gemäß der allgemeinen Formel [M(L_{C})(L_{T})(L_{Z})] (I), sind aufgrund ihrer hohen Reinheit (gemäß ¹H-NMR-spektroskopischer Untersuchung) von wenigstens 97%, vorteilhaft von mehr als 97%, insbesondere von mehr als 98% oder 99%, besonders gut als Präkursorverbindung oder als Präkursorverbindung enthaltende Lösung zur Herstellung einer qualitativ hochwertigen Schicht auf einer Oberfläche eines Substrats geeignet. Dabei besteht die Schicht aus wenigstens einem Metall, ausgewählt aus der Gruppe bestehend aus Scandium, Yttrium, Lanthanoiden, wobei das Lanthanoid beispielsweise La, Ce, Nd, Eu, Er oder Lu ist, und Titan. Auch zur Herstellung einer qualitativ hochwertigen Schicht, enthaltend wenigstens ein Metall, ausgewählt aus der Gruppe bestehend aus Scandium, Yttrium, Lanthanoiden, wobei das Lanthanoid beispielsweise La, Ce, Nd, Eu, Er oder Lu ist, und Titan, eignen sich die vorgenannten Metallkomplexe gemäß der allgemeinen Formel I sowie Lösungen, umfassend wenigstens einen solchen Metallkomplex.

Im Zusammenhang mit der vorliegenden Erfindung beziehen sich der Ausdruck "hohe Reinheit" und der Begriff "hochrein" auf einen Gesamtgehalt an Verunreinigungen durch unerwünschte Metalle, unerwünschte Halbmetalle, Luftsauerstoff und Wasser, von unter 1 ppm, idealerweise von unter 100 ppb. In der Halbleiterindustrie wird ein solcher Reinheitsgrad als *electronic grade* bezeichnet. Potenzielle Verunreinigungen durch flüchtige organische Verbindungen, insbesondere durch im Rahmen der Synthese eingesetzte organische Lösungsmittel, sind bei dieser Reinheitsangabe nicht berücksichtigt. In Bezug auf diese Art von Verunreinigung beträgt die Reinheit der Metallkomplexe gemäß Formel I üblicherweise wenigstens 97%, vorteilhaft mehr als 97%, insbesondere mehr als 98% oder 99%.

Die Abscheidung der jeweiligen Scandiumschicht, Yttriumschicht, Lanthanoidschicht, wobei das Lanthanoid beispielsweise La, Ce, Nd, Eu, Er oder Lu ist, oder Titanschicht oder der wenigstens eines der vorgenannten Metalle enthaltenden Schicht kann mittels eines CVD-Verfahrens erfolgen, zum Beispiel mittels eines MOCVD-Verfahrens, eines MOVPE-Verfahrens oder eines ALD-Verfahrens.

Als Substrat können beispielsweise Korundfolien oder dünne metallische Folien eingesetzt werden. Das Substrat kann selbst Teil eines Bauteils sein und/oder bereits mit einer Halbleiterschicht versehen sein, zum Beispiel mit einer Schicht bestehend aus einem III-V-Halbleiter wie Galliumnitrid (GaN).

In einer Ausführungsform des hier beschriebenen Verfahrens ist das Substrat ein Wafer. Der Wafer kann Silicium, Siliciumcarbid, Germanium, Galliumnitrid, Galliumarsenid, Indiumphosphid, ein Glas, wie z. B. SiO₂, und/oder einen Kunststoff, wie z. B. Silikon, umfassen oder vollständig aus einem oder mehreren dieser Materialien bestehen. Zudem kann der Wafer eine oder mehrere Waferschichten mit jeweils einer Oberfläche aufweisen. Die Herstellung einer Schicht, bestehend aus wenigstens einem Metall, ausgewählt aus der Gruppe bestehend aus Scandium, Yttrium, Lanthanoiden, wobei das Lanthanoid beispielsweise La, Ce, Nd, Eu, Er oder Lu ist, und Titan, oder einer Schicht, enthaltend wenigstens ein Metall, ausgewählt aus der Gruppe bestehend aus Scandium, Yttrium, Lanthanoiden, wobei das Lanthanoid beispielsweise La, Ce, Nd, Eu, Er oder Lu ist, und Titan, kann auf der Oberfläche einer oder mehrerer Waferschichten vorgesehen sein. Bei der wenigstens ein Metall enthaltenden Schicht kann es sich um eine Ln₂O₃-Schicht handeln, beispielsweise auch um eine Schicht enthaltend ein Mischoxid zweier Lanthanoide oder bestehend aus einem Mischoxid zweier Lanthanoide.

Des Weiteren wird die Aufgabe gelöst durch ein Verfahren zur Herstellung eines elektronischen Bauelements, insbesondere eines elektronischen Halbleiterbauelements, unter Verwendung
- wenigstens eines Metallkomplexes gemäß der allgemeinen Formel [M(L_{C})(L_{T})(L_{Z})] (I) nach einer oder mehreren der weiter oben beschriebenen Ausführungsformen,
   oder
- einer Lösung, umfassend wenigstens einen Metallkomplex gemäß der allgemeinen Formel [M(L_{C})(L_{T})(L_{Z})] (I) nach einer oder mehreren der weiter oben beschriebenen Ausführungsformen und ein aprotisch-unpolares Lösungsmittel.

Dabei umfasst das Verfahren die folgenden Schritte:
A. Zurverfügungstellung
   - des wenigstens einen Metallkomplexes gemäß der allgemeinen Formel [M(L_{C})(L_{T})(L_{Z})] (I) nach einer oder mehreren weiter oben beschriebenen Ausführungsformen,
      oder
   - der Lösung, umfassend wenigstens einen Metallkomplex gemäß der allgemeinen Formel [M(L_{C})(L_{T})(L_{Z})] (I) nach einer oder mehreren der weiter oben beschriebenen Ausführungsformen und ein aprotisch-unpolares Lösungsmittel,
B. Abscheidung einer Schicht, welche
   i. aus dem wenigstens einen Metall M besteht,
      oder
   ii. das wenigstens eine Metall M enthält,
   auf einer Oberfläche eines Substrats,
   und
C. Fertigstellung des elektronischen Bauelements, insbesondere des elektronischen Halbleiterbauelements.

Das elektronische Bauelement, insbesondere das elektronische Halbleiterbauelement, ist zum Beispiel ein Detektor, ein Fotoelement, eine Halbleiterdiode, ein Laser, ein elektronisches Schaltelement, insbesondere ein Feldeffekttransistor oder ein Transistor mit hoher Elektronenbeweglichkeit, oder ein faseroptischer Emitter oder ein faseroptischer Sensor.

Der wenigstens eine zu verwendende Metallkomplex des weiter oben beschriebenen Typs [M(L_{C})(L_{T})(L_{Z})] (I) oder die zu verwendende Lösung, umfassend wenigstens einen Metallkomplex gemäß der allgemeinen Formel [M(L_{C})(L_{T})(L_{Z})] (I), sind aufgrund ihrer hohen Reinheit besonders gut als Präkursorverbindung oder als Präkursorverbindung enthaltende Lösung zur Herstellung einer qualitativ hochwertigen Schicht auf einer Oberfläche eines Substrats geeignet.

Eine Definition des Ausdrucks "hohe Reinheit" ist angegeben im Zusammenhang mit dem Verfahren zur Herstellung einer Schicht, welche aus wenigstens einem Metall M besteht, oder einer Schicht, welche wenigstens ein Metall M enthält, auf einer Oberfläche eines Substrats.

Die Abscheidung der jeweiligen Scandiumschicht, Yttriumschicht, Lanthanoidschicht, wobei das Lanthanoid beispielsweise La, Ce, Nd, Eu, Er oder Lu ist, oder Titanschicht oder der wenigstens eines der vorgenannten Metalle enthaltenden Schicht kann mittels eines CVD-Verfahrens erfolgen, zum Beispiel mittels eines MOCVD-Verfahrens, eines MOVPE-Verfahrens oder eines ALD-Verfahrens.

Das Substrat kann zum Beispiel eine Korundfolie oder eine dünne metallische Folie sein. Es kann selbst Teil eines Bauteils sein und/oder bereits mit einer Halbleiterschicht versehen sein, zum Beispiel mit einer Schicht bestehend aus einem III-V-Halbleiter wie Galliumnitrid (GaN).

In einer Ausführungsform des hier beschriebenen Verfahrens ist das Substrat ein Wafer. Der Wafer kann Silicium, Siliciumcarbid, Germanium, Galliumnitrid, Galliumarsenid, Indiumphosphid, ein Glas, wie z. B. SiO₂, und/oder einen Kunststoff, wie z. B. Silikon, umfassen oder vollständig aus einem oder mehreren dieser Materialien bestehen. Zudem kann der Wafer eine oder mehrere Waferschichten mit jeweils einer Oberfläche aufweisen. Die Herstellung einer Schicht, bestehend aus wenigstens einem Metall, ausgewählt aus der Gruppe bestehend aus Scandium, Yttrium, Lanthanoiden, wobei das Lanthanoid beispielsweise La, Ce, Nd, Eu, Er oder Lu ist, und Titan, oder einer Schicht, enthaltend wenigstens ein Metall, ausgewählt aus der Gruppe bestehend aus Scandium, Yttrium, Lanthanoiden, wobei das Lanthanoid beispielsweise La, Ce, Nd, Eu, Er oder Lu ist, und Titan, kann auf der Oberfläche einer oder mehrerer Waferschichten vorgesehen sein. Bei der wenigstens ein Metall enthaltenden Schicht kann es sich um eine Ln₂O₃-Schicht handeln, beispielsweise auch um eine Schicht enthaltend ein Mischoxid zweier Lanthanoide oder bestehend aus einem Mischoxid zweier Lanthanoide.

Weitere Merkmale, Einzelheiten und Vorteile der Erfindung ergeben sich aus dem Wortlaut der Ansprüche sowie aus der folgenden Beschreibung von Ausführungsbeispielen und Zeichnungen. Es zeigen:
- **Fig. 1**: eine TGA-Kurve und eine SDTA-Kurve (Kurve einer mit der TGA-Messung gleichzeitig durchgeführten differenziellen thermischen Analyse; engl. *synchronous differential thermal analysis*) des Metallkomplexes [(EtCp)₂Sc(dbt)], wobei dbt = Di-*tert*-butyl-triazenid-Anion ist, hergestellt gemäß Beispiel 3.1;
- **Fig. 2**: eine TGA-Kurve und eine SDTA-Kurve des Metallkomplexes [(EtCp)Sc(dbt)_{2]}, wobei dbt = Di-*tert*-butyl-triazenid-Anion ist, hergestellt gemäß Beispiel 4; und
- **Fig. 3**: eine TGA-Kurve und eine SDTA-Kurve des vorbekannten Komplexes [(MeCp)₂ScCl]₂.

Die in **Fig. 1** und in **Fig. 2** gezeigten TGA-Kurven wurden von zwei Metallkomplexen gemäß der allgemeinen Formel I aufgenommen, wobei für beide Komplexe gilt: M = Sc, Lc = EtCp⁻ und L_{T} = (*t*Bu-N₃-*t*Bu)⁻. Für den ersten Metallkomplex gilt außerdem Lz = Lc, für den zweiten Metallkomplex gilt Lz = L_{T}.

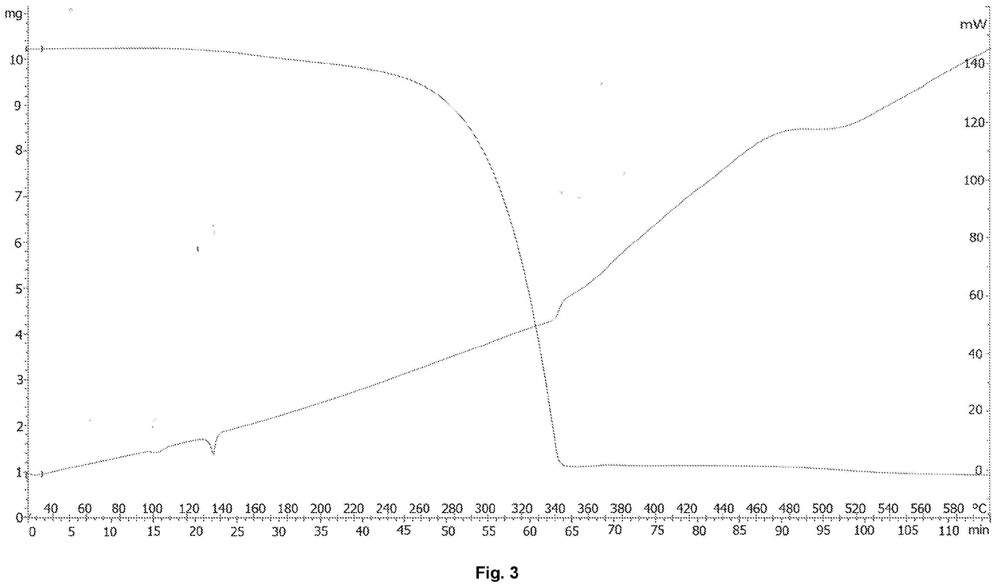

In **Fig. 3** ist zu Vergleichszwecken eine TGA-Kurve des vorbekannten Präkursormaterials [(MeCp)₂ScCl]₂ abgebildet. Dieser Sc(III)-Komplex wurde gemäß einer in WO 2018/086730 A9 angegebenen Vorschrift hergestellt.

Auf der x-Achse ist jeweils - sowohl für die TGA-Messung als auch für die SDTA-Messung - die Temperatur in °C aufgetragen, wobei die relevanten Zahlenwerte oberhalb der x-Achse angegeben sind.

Für die TGA-Messung ist zudem die linke y-Achse von Bedeutung, auf welcher die Einwaage in mg aufgetragen ist, sowie die zweite y-Achse (von links; in **Fig. 3** nicht gezeigt), auf welcher die verbleibende Masse in % aufgetragen ist. Auf der für die SDTA-Messung relevanten rechten y-Achse ist die Wärmestromdifferenz in mW aufgetragen.

Aus den in **Fig. 1** und in **Fig. 2** gezeigten TGA-Kurven geht hervor, dass sowohl der Sc(III)-Komplex [(EtCp)₂Sc(dbt)] als auch der Sc(III)-Komplex [(EtCp)Sc(dbt)₂] bei niedrigen Temperaturen, nämlich im Bereich von 200 °C, vorteilhafterweise zersetzungsfrei verdampfbar sind. Die niedrigen Schmelztemperaturen dieser Verbindungen sind aus den jeweils zugehörigen SDTA-Kurven ablesbar: *ca.* 10 °C im Falle des Komplexes [(EtCp)₂Sc(dbt)] und ca. 45 °C für die Verbindung [(EtCp)Sc(dbt)₂]).

Im Unterschied dazu geht aus der in **Fig. 3** dargestellten TGA-Kurve hervor, dass der vorbekannte Sc(III)-Präkursor [(MeCp)₂ScCl]₂ unvorteilhafterweise keine zersetzungsfreie Verdampfung zeigt. Die Schmelztemperatur dieses vorbekannten Komplexes beträgt ca. 160 °C.

Aufgrund der Tatsache, dass die Sc(III)-Komplexe [(EtCp)₂Sc(dbt)] und [(EtCp)Sc(dbt)₂] in hoher Reinheit, auch im großtechnischen Maßstab, herstellbar und zersetzungsfrei verdampfbar sind - Letzteres sogar bei relativ niedrigen Temperaturen im Bereich von 200 °C - sind sie als Präkursormaterialien in Verfahren der chemischen Gasphasenabscheidung (CVD-Verfahren), insbesondere zur Erzeugung qualitativ hochwertiger Scandiumschichten oder Scandium enthaltender Schichten, z. B. AlScN-Schichten, auf Halbleitersubstraten prädestiniert. Dies wurde beispielsweise durch Einsatz des Komplexes [(EtCp)₂Sc(dbt)] in einem MOVPE-Verfahren bestätigt. Diesbezügliche Informationen sind weiter oben angegeben.

### Arbeitsvorschriften zur Synthese von [(EtCp)₂Y(dbt)], [(MeCp)₂Sc(dbt)], [(EtCp)₂Sc(dbt)], [(EtCp)Sc(dbt)₂], [(Cp)₂Ti(pbt)], [(iPrCp)(EtCp)Eu(dbt)], [(iPrCp)Lu(dbt)₂], [(tBuCp)Er(dmt)(dpt)], [(Et₂Cp)La(dbt)₂], [(Cp*)(MeCp)Ce(dmt)], [(iPrCp)(MeCp)Nd(dibt)]

Dabei gilt:
Cp = Cyclopentadienid-Anion, C₅H₅⁻; MeCp = Methylcyclopentadienid-Anion, MeC₅H₄⁻; EtCp = Ethylcyclopentadienid-Anion, EtC₅H₄⁻; Et₂Cp = Di-ethylcyclopentadienid-Anion, Et₂C₅H₃⁻; *i*PrCp = *iso*-Propyl-cyclopentadienid-Anion, *i*PrC₅H₄⁻; *t*BuCp = *tert*-Butylcyclopentadienid-Anion, *t*BuC₅H₄⁻; Cp* = 1,2,3,4,5-Pentamethylcyclopentadienid-Anion, C₅Me₅⁻; dmt = Di-methyl-triazenid-Anion, (Me-N₃-Me)⁻; dpt = Di-*iso*-propyl-triazenid-Anion, (*i*Pr-N₃-*i*Pr)⁻; pbt = *iso*-Propyl*tert*-butyl-triazenid-Anion, (*i*Pr-N₃-*t*Bu)⁻; dbt = Di-*tert*-butyl-triazenid-Anion, (*t*Bu-N₃-*t*Bu)⁻; dibt = Di-*iso*-butyl-triazenid-Anion (*i*Bu-N₃-*i*Bu)⁻.

### Materialien und Methoden

Alle Reaktionen wurden unter Schutzgasatmosphäre mit Hilfe gängiger Schlenk-Techniken durchgeführt. Die eingesetzten Edukte und Lösungsmittel wiesen den Reinheitsgrad *p.a.* auf.

Alle kernresonanzspektroskopischen Messungen wurden an einem Gerät des Typs Bruker AV II 300 durchgeführt. ¹H-NMR- und ¹³C-NMR-Spektren wurden auf das entsprechende Restprotonensignal des Lösungsmittels (C₆D₆) als interner Standard kalibriert: **¹H**: 7,16 ppm (s); **¹³C**: 128,0 ppm (tr). Die chemischen Verschiebungen werden in ppm angegeben und beziehen sich auf die δ-Skala. Alle Signale werden entsprechend ihres Aufspaltungsmusters mit den folgenden Abkürzungen versehen: s (Singulett), t (Triplett), q (Quartett) oder m (Multiplett). Die Kopplung zwischen zwei Kernen A und B über n Bindungen werden durch die Kopplungskonstante der Form ⁿ*J*_{AB} in Hertz (Hz) angegeben.

Die Messungen von Infrarotspektren erfolgten in Substanz in der Regel an einem Alpha ATR-IR-Spektrometer der Firma Bruker. Die Absorptionsbanden sind angegeben in Wellenzahl (cm⁻¹) und die Intensität wird mit folgenden Abkürzungen beschrieben: w (schwach), m (mittelstark), s (stark). Normiert wurden die Spektren stets auf die intensitätsstärkste Bande.

Die thermogravimetrischen Untersuchungen wurden an einem TGA/DSC 3+ STAR System der Firma Mettler Toledo durchgeführt. Dabei wurde bei jeder TGA-Messung eine gekoppelte SDTA-Messung durchgeführt. Die Proben wurden je nach Methode beziehungsweise je nach Aggregatzustand in Aluminiumoxid-, Aluminium- oder Saphirtiegeln gemessen. Die Probe wurde mit jeweils einer bestimmten Heizrate zwischen 5 K/min und 25 K/min bis zur Endtemperatur erhitzt. Die Auswertung der erhaltenen Spektren erfolgte mit STARe Software der Firma Mettler Toledo.

### Beispiel 1.1: Darstellung von [(EtCp)₂Y(dbt)] ausgehend von YCl₃

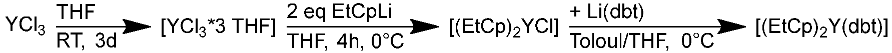

5,0 g YCl₃ (25,6 mmol) wurden bei -60°C in 150 mL THF aufgenommen und nach Erwärmen auf Raumtemperatur für 3 Tage gerührt. Zu der entstandenen farblosen Suspension wurde eine Lösung von EtCpLi (56,3 mmol) in 50 mL THF bei 0°C innerhalb von 4 Stunden getropft. Das Reaktionsgemisch klarte beim Auftauen auf Raumtemperatur vollständig auf und wurde für 16 Stunden bei Raumtemperatur gerührt. Das Lösungsmittel wurde im Vakuum entfernt. Der erhaltene Rückstand wurde in 50 mL Toluol aufgenommen und die so erhaltene Suspension wurde filtriert. Der Filterkuchen wurde dreimal mit je 20 mL Toluol gewaschen. Das Filtrat wurde mit 50 mL Toluol verdünnt und auf 0 °C gekühlt. Anschließend wurden 4,2 g Li(dbt) (25,6 mmol) portionsweise dazugegeben. Das Reaktionsgemisch wurde zunächst auf Raumtemperatur erwärmt und anschließend für 3 Stunden zum Sieden erhitzt. Die erhaltene Suspension wurde filtriert. Das Lösungsmittel des Filtrats wurde im Vakuum entfernt und das Rohprodukt im Vakuum bei 180 °C um kondensiert. Das Produkt wurde als farbloses Öl erhalten, welches bei Raumtemperatur langsam zu einem farblosen Feststoff erstarrte. Ausbeute: 75% (6,0 g; 19,3 mmol).

### Beispiel 1.2: Darstellung von [(EtCp)₂Y(dbt)] ausgehend von [(EtCp)₂YCl]

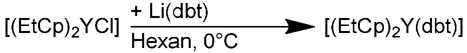

Zu 90,5 g (EtCp)₂YCl (291 mmol) in 600 mL *n*-Hexan wurden bei 0 °C 47,5 g Li(dbt) (291 mmol) portionsweise über 2 Stunden dazugegeben. Das Reaktionsgemisch wurde für 2 Stunden bei 0 °C und anschließend für 16 h bei Raumtemperatur gerührt. Anschließend wurde das Reaktionsgemisch für 3 Sieden zum Sieden erhitzt. Die erhaltene Suspension wurde filtriert und der Filterkuchen dreimal mit je 50 mL *n*-Hexan gewaschen. Das Lösungsmittel des Filtrats wurde im Vakuum entfernt und das Rohprodukt im Vakuum bei 180 °C umkondensiert. Das Produkt wurde als farbloses Öl erhalten, welches bei Raumtemperatur langsam erstarrte. Ausbeute: 78% (98 g; 227 mmol).

**Schmelztemperatur:** *ca.* 40 °C; **¹H-NMR** (300 MHz; C₆D₆): δ = 1,14 (t, ³*J*_{HH} = 7,6 H, 6H, CH₂C*H*₃), 1,20 (s, 18H, C(C*H*₃)₃), 2,45 (q, ³*J*_{HH} = 7,6 H, 4H, C*H*₂CH₃), 5,96 (m, 4H, CH_{arom.}), 6,02 (m, 4H, CH_{arom.}) ppm; **¹³C-NMR** (75 MHz; C₆D₆): δ = 16,4 (s, 2C, CH₂*C*H₃), 23,3 (s, 2C, *C*H₂CH₃), 30,2 (s, 6C, C(*C*H₃)₃), 56,8 (s, 1C, *C*(CH₃)₃), 56,9 (s, 1C, *C*(CH₃)₃), 110,2 (s, 1C, *C*Hₐᵣₒₘ), 110,2 (s, 1C, CH_{arom.}) ,110,7 (s, 1C *C*Hₐᵣₒₘ), 110,7 (s, 1C, *C*H_{arom.}),130,3 (s, 1C, *C*_{arom. quatär}) ppm; **IR** (Substanz): *ν̃* = 3064 (w), 2965 (m), 2928 (w), 2897 (w), 2867 (w), 1471 (w), 1459 (w), 1382 (w), 1357 (m), 1318 (w), 1278 (s), 1248 (m), 1202 (s), 1043 (w), 1027 (m), 911 (w), 854 (m), 764 (s), 665 (w), 619 (s), 554 (w), 487 (w), 465 (w), 426 (w) cm⁻¹.

### Beispiel 2: Darstellung von [(MeCp)₂Sc(dbt)]

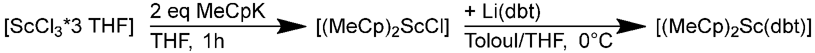

7,35 g [ScCl₃*3 THF] (20 mmol) wurden in 50 mL THF suspendiert. Eine Lösung von MeCpK (40 mmol) in 100 mL THF wurde bei Raumtemperatur innerhalb von 1 Stunde zugetropft. Das Reaktionsgemisch wurde anschließend für 16 Stunden bei Raumtemperatur gerührt. Das Lösungsmittel wurde im Vakuum entfernt und der Rückstand in 50 mL Toluol aufgenommen. Die erhaltene Suspension wurde filtriert und der Filterkuchen dreimal mit je 20 mL Toluol gewaschen. Das Filtrat wurde auf ein Volumen von ca. 30 mL eingeengt und auf 0 °C gekühlt. Anschließend wurden 3,2 g Li(dbt) (20 mmol) portionsweise zugegeben. Nach dem Auftauen wurden 5 mL THF zugegeben und das Reaktionsgemisch für 16 Stunden bei Raumtemperatur gerührt. Die erhaltene Suspension wurde filtriert, das Lösungsmittel des Filtrats im Vakuum entfernt und das Rohprodukt im Vakuum bei 150 °C kondensiert. Das Produkt wurde als gelblicher Feststoff erhalten. Ausbeute: 66% (5 g; 13,3 mmol).

**Schmelztemperatur:** *ca.* 80°C (geschätzt); **¹H-NMR** (300 MHz; C₆D₆): δ = 1,23 (s, 18H, C(C*H*₃)₃), 1,98 (s, 6H, cp-C*H*₃), 5,82 (m, 4H, CHarom.), 6,89 (m, 4H, CH_{arom.}) ppm; **¹³C-NMR** (75 MHz; C₆D₆): δ = 15,7 (s, 2C, cp-*C*H₃), 30,4 (s, 6C, C(*C*H₃)₃), 57,3 (s, 2C, *C*(CH₃)₃), 110,3 (s, 2C, *C*Hₐᵣₒₘ), 113,5 (s, 2C, *C*Hₐᵣₒₘ), 121,4 (s, 1C, *C*_{arom. quatär}) ppm; **IR** (Substanz): *ν̃* = 2965 (m), 2925 (w), 2898 (w), 2864 (w), 1469 (w),1454 (w), 1383 (w), 1354 (m), 1283 (s), 1243 (m), 1201 (s),1047 (m), 932 (w), 842 (m), 773 (s), 618 (s), 555 (w), 493 (m), 469 (m), 436 (w), 425 (w) cm⁻¹.

### Anmerkung zu Beispiel 2:

Die Synthese von [(MeCp)₂Sc(dbt)] kann - analog zu Beispiel 1.2 - ausgehend von [(MeCp)₂ScCl] erfolgen.

### Beispiel 3.1: Darstellung von [(EtCp)₂Sc(dbt)] ausgehend von [ScCl₃*3 THF]

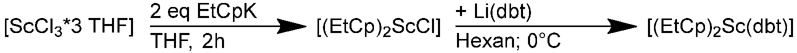

206,6 g [ScCl₃*3 THF] (562 mmol) wurden als Feststoff portionsweise innerhalb von 3 Stunden zu einer Lösung von EtCpK (1,12 mol) in 900 mL THF bei 0 °C gegeben. Das Reaktionsgemisch wurde anschließend für 2 Stunden bei Raumtemperatur gerührt und daraufhin für 5 Stunden zum Sieden erhitzt. Das Lösungsmittel wurde im Vakuum entfernt und der Rückstand in 500 mL n-Hexan aufgenommen. Die erhaltene Suspension wurde heiß filtriert und der Rückstand dreimal mit je 100 mL *n*-Hexan gewaschen. Das Filtrat wurde auf ein Volumen von ca. 250 mL eingeengt und über Nacht bei 0 °C gelagert. Das kristalline [(EtCp)₂ScCl] wurde anschließend durch Dekantieren von der Mutterlauge getrennt und der Rückstand im Vakuum getrocknet (Ausbeute: 75%; 127 g; 477 mmol). Durch erneute Kristallisation aus der Mutterlauge konnte die Ausbeute an [(EtCp)₂ScCl] weiter erhöht werden.

73 g [(EtCp)₂ScCl] (273 mmol) wurden in einem 1 L -Kolben in 500 mL n-Hexan gelöst. Anschließend wurden portionsweise 44,6 g Li(dbt) (273 mmol) bei 0 °C dazugegeben. Nach dem Auftauen wurde für 16 Stunden bei Raumtemperatur gerührt. Die erhaltene Suspension wurde für 3 Stunden zum Sieden erhitzt und anschließend heiß filtriert. Das Lösungsmittel des Filtrats wurde destillativ entfernt. [(EtCp)₂Sc(dbt)] wurde durch Destillation des Rückstands (im dynamischen Vakuum, d. h. bei ca. 1*10⁻³ mbar, bei 155 °C) in Form eines gelben Öls erhalten. Ausbeute: 73% (80 g; 201 mmol).

### Beispiel 3.2: Darstellung von [(EtCp)₂Sc(dbt)] ausgehend von [(EtCp)₂ScCl]

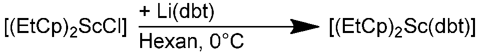

Zu 70 g [(EtCp)₂ScCl] (262 mmol) in 600 mL *n*-Hexan wurden über 2 Stunden bei 0 °C 42,8 g Li(dbt) (262 mmol) portionsweise gegeben. Das Reaktionsgemisch wurde für 2 Stunden bei 0 °C und danach für 16 h bei Raumtemperatur gerührt. Anschließend wurde das Reaktionsgemisch für 3 Stunden zum Sieden erhitzt. Die erhaltene Suspension wurde filtriert und der Filterkuchen dreimal mit je 50 mL n-Hexan gewaschen. Das Lösungsmittel des Filtrats wurde im Vakuum entfernt. [(EtCp)₂Sc(dbt)] wurde durch Destillation des Rückstands (im dynamischen Vakuum, d. h. bei ca. 1*10⁻³ mbar, bei 155 °C) in Form eines gelben Öls erhalten. Ausbeute: 81% (82 g; 212 mmol).

**Schmelztemperatur:** *ca.* 10 °C; **¹H-NMR** (300 MHz; C₆D₆): δ = 1,13 (t, ³*J*_{HH} = 7,6 H, 6H, CH₂C*H*₃), 1,24 (s, 18H, C(C*H*₃)₃), 2,37 (q, ³*J*_{HH} = 7,6 H, 4H, C*H*₂CH₃), 5,89 (m, 8H, CHarom.) ppm; **¹³C-NMR** (75 MHz; C₆D₆): δ = 16,4 (s, 2C, CH₂*C*H₃), 23,8 (s, 2C, *C*H₂CH₃), 30,4 (s, 6C, C(*C*H₃)₃), 57,4 (s, 1C, *C*(CH₃)₃), 110,4 (s, 4C, *C*H_{arom.}), 112,1 (s, 4C, *C*H_{arom.}), 128,6 (s, 2C, *C*_{arom, quartär}) ppm.

### Beispiel 4: Darstellung von [(EtCp)Sc(dbt)₂] ausgehend von [ScCl₃*3 THF]

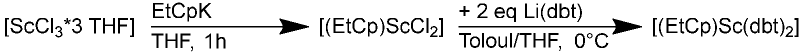

7,35 g [ScCl₃*3 THF] (20 mmol) wurden in 50 mL THF suspendiert. Eine Lösung von EtCpK (20 mmol) in 100 mL THF wurde bei Raumtemperatur innerhalb von 1 Stunde zugetropft. Das Reaktionsgemisch wurde anschließend für 16 Stunden bei Raumtemperatur gerührt. Das Lösungsmittel wurde im Vakuum entfernt und der Rückstand in 50 mL Toluol aufgenommen. Die erhaltene Suspension wurde filtriert und der Filterkuchen dreimal mit je 20 mL Toluol gewaschen. Das Filtrat wurde auf ein Volumen von ca. 30 mL eingeengt und auf 0 °C gekühlt. Anschließend wurden 6,4 g Li(dbt) (20 mmol) portionsweise zugegeben. Nach dem Auftauen wurden 5 mL THF zugegeben und das Reaktionsgemisch für 16 Stunden bei Raumtemperatur gerührt. Die erhaltene Suspension wurde filtriert, das Lösungsmittel des Filtrats im Vakuum entfernt und das Rohprodukt im Vakuum bei 150°C kondensiert. Das Produkt wurde als gelblicher Feststoff erhalten. Ausbeute: 73% (6,6 g; 14,6 mmol).

**Schmelztemperatur:** *ca.* 45 °C; **¹H-NMR** (300 MHz; C₆D₆): δ = 1,18 (t, ³*J*_{HH} = 7,6 H, 3H, C*H*₃), 1,31 (s, 36H, NC(C*H*₃)₃), 2,55 (q, ³*J*_{HH} = 7,6 Hz, 2H, C*H*₂), 6,28 (s, 4H, CpH) ppm.

### Beispiel 5: Darstellung von [Cp₂Ti(pbt)] ausgehend von [Cp₂TiCl]

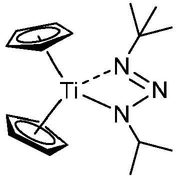

Zu 10,68 g [Cp₂TiCl] (50 mmol) in 150 mL n-Hexan wird bei 0 °C 7,46 g Li(pbt) (50 mmol) portionsweise über 2 Stunden gegeben. Das Reaktionsgemisch wird für 2 Stunden bei 0 °C und danach für 16 h bei Raumtemperatur gerührt. Anschließend wird das Reaktionsgemisch für 3 Stunden zum Sieden erhitzt. Die erhaltene Suspension wird filtriert und der Filterkuchen dreimal mit je 50 mL *n-*Hexan gewaschen. Das Lösungsmittel des Filtrats wird im Vakuum entfernt. [(Cp)₂Ti(pbt)] wird durch Destillation des Rückstands erhalten.

Aus der erfolgreichen Synthese gemäß Beispiel 1.2 und gemäß Beispiel 3.2 wird die Schlussfolgerung gezogen, dass eine Umsetzung von [Cp₂TiCl] mit Li(pbt) - analog zu Beispiel 1.2 und Beispiel 3.2 - die gewünschte Zielverbindung [(Cp)₂Ti(pbt)] zum Ergebnis hat.

Gemäß Beispiel 1.2 wurde ausgehend von [(EtCp)₂YCl] und Li(dbt) die Verbindung [(EtCp)₂Y(dbt)] erhalten. Analog wurde gemäß Beispiel 3.2 ausgehend von [(EtCp)₂ScCl] und Li(dbt) der Komplex [(EtCp)₂Sc(dbt)] erhalten, und zwar in vergleichbarer Ausbeute und Reinheit wie der Komplex [(EtCp)₂Y(dbt)].

Wird anstelle von [(EtCp)₂YCl] oder [(EtCp)₂ScCl] der Titan(III)-Komplex [Cp₂TiCl] - analog zu Beispiel 1.2 oder Beispiel 3.2 - mit Li(pbt) umgesetzt, wird [(Cp)₂Ti(pbt)] erhalten. Denn Ti³⁺-Komplexe, Y³⁺-Komplexe und Sc³⁺-Komplexe verhalten sich chemisch analog.

Ausbeute und Reinheit von [(Cp)₂Ti(pbt)], welche gemäß diesem Beispiel erzielt werden, sind ähnlich oder identisch zu denjenigen, welche mittels den weiter oben für [(EtCp)₂Y(dbt)] (Beispiel 1.2) und für [(EtCp)₂Sc(dbt)] (Beispiel 3.2) beschriebenen Synthesen erhalten wurden.

### Beispiel 6: Darstellung von [(iPrCp)(EtCp)Eu(dbt)] ausgehend von [(iPrCp)(EtCp)EuCl]

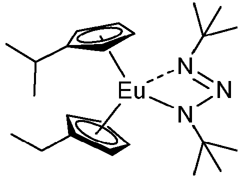

Zu 19,4 g **[(*i*PrCp)(EtCp)EuCl]** (50 mmol) in 150 mL *n*-Hexan werden bei 0 °C 8,16 g Li(dbt) (50 mmol) portionsweise über 2 Stundengegeben. Das Reaktionsgemisch wird für 2 Stunden bei 0 °C und danach für 16 Stunden bei Raumtemperatur gerührt. Anschließend wird das Reaktionsgemisch für 3 Stunden zum Sieden erhitzt. Die erhaltene Suspension wird filtriert und der Filterkuchen dreimal mit je 50 mL *n*-Hexan gewaschen. Das Lösungsmittel des Filtrats wird im Vakuum entfernt. [(*i*PrCp)(EtCp)Eu(dbt)] wird durch Destillation des Rückstands erhalten.

Aus der erfolgreichen Synthese gemäß Beispiel 1.2 und gemäß Beispiel 3.2 wird die Schlussfolgerung gezogen, dass eine Umsetzung von [(*i*PrCp)(EtCp)EuCl] mit Li(pbt) - analog zu Beispiel 1.2 und Beispiel 3.2 - die gewünschte Zielverbindung [(*i*PrCp)(EtCp)Eu(dbt)] zum Ergebnis hat.

Gemäß Beispiel 1.2 wurde ausgehend von [(EtCp)₂YCl] und Li(dbt) die Verbindung [(EtCp)₂Y(dbt)] erhalten. Analog wurde gemäß Beispiel 3.2 ausgehend von [(EtCp)₂ScCl] und Li(dbt) der Komplex [(EtCp)₂Sc(dbt)] erhalten, und zwar in vergleichbarer Ausbeute und Reinheit wie der Komplex [(EtCp)₂Y(dbt)].

Wird anstelle von [(EtCp)₂YCl] oder [(EtCp)₂ScCl] der Europium(III)-Komplex [(*i*PrCp)(EtCp)EuCl] - analog zu Beispiel 1.2 oder Beispiel 3.2 - mit Li(pbt) umgesetzt, wird [(iPrCp)(EtCp)Eu(dbt)] erhalten. Denn Lanthanoid(III)-Komplexe, wie beispielsweise der hier als Edukt vorgesehene Eu³⁺-Komplex, verhalten sich chemisch analog zu Y³⁺-Komplexen und Sc³⁺-Komplexen.

Ausbeute und Reinheit von [(iPrCp)(EtCp)Eu(dbt)], welche gemäß diesem Beispiel erzielt werden, sind ähnlich oder identisch zu denjenigen, welche mittels den weiter oben für [(EtCp)₂Y(dbt)] (Beispiel 1.2) und für [(EtCp)₂Sc(dbt)] (Beispiel 3.2) beschriebenen Synthesen erhalten wurden.

### Beispiel 7: Darstellung von [(iPrCp)Lu(dbt)₂] ausgehend von [(iPrCp)LuCl₂]

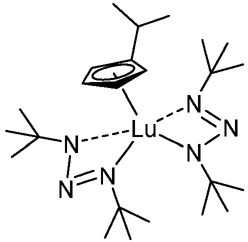

Zu 17,65 g [(*i*PrCp)LuCl₂] (50 mmol) in 150 mL n-Hexan werden bei 0 °C 16,32 g Li(dbt) (100 mmol) portionsweise über 2 Stunden gegeben. Das Reaktionsgemisch wird für 2 Stunden bei 0 °C und anschließend für 16 Stunden bei Raumtemperatur gerührt. Anschließend wird das Reaktionsgemisch für 3 Stunden zum Sieden erhitzt. Die erhaltene Suspension wird filtriert und der Filterkuchen dreimal mit je 50 mL *n*-Hexan gewaschen. Das Lösungsmittel des Filtrats wird im Vakuum entfernt. [(*i*PrCp)Lu(dbt)₂] wird durch Destillation des Rückstands erhalten.

Aus der erfolgreichen Synthese gemäß Beispiel 1.2 und gemäß Beispiel 3.2 wird die Schlussfolgerung gezogen, dass eine Umsetzung von *iso*-Propylcyclopentadienyl-lutetiumdichlorid [(*i*PrCp)LuCl₂] mit Li(pbt) - analog zu Beispiel 1.2 und Beispiel 3.2, wobei jedoch ein molares Verhältnis [(*i*PrCp)LuCl₂] : Li(pbt) 1 : 2 beträgt - die gewünschte Zielverbindung [(*i*PrCp)Lu(dbt)₂] zum Ergebnis hat.

Gemäß Beispiel 4 wurde ausgehend von [(EtCp)₂YCl] und Li(dbt), wobei ein molares Verhältnis der Edukte 1 : 1 betrug, die Verbindung [(EtCp)₂Y(dbt)] erhalten. Analog wurde gemäß Beispiel 3.2 ausgehend von [(EtCp)₂ScCl] und Li(dbt) der Komplex [(EtCp)₂Sc(dbt)] erhalten, und zwar in vergleichbarer Ausbeute und Reinheit wie der Komplex [(EtCp)₂Y(dbt)].

Wird anstelle von [(EtCp)₂YCl] oder [(EtCp)₂ScCl] der Lutetium(III)-Komplex [(*i*PrCp)LuCl₂] - analog zu Beispiel 1.2 oder Beispiel 3.2, wobei jedoch ein molares Verhältnis [(*i*PrCp)LuCl₂] : Li(pbt) 1 : 2 beträgt - mit Li(pbt) umgesetzt, wird [(*i*PrCp)Lu(dbt)₂] erhalten. Denn Lanthanoid(III)-Komplexe, wie beispielsweise der hier als Edukt vorgesehene Lu³⁺-Komplex, verhalten sich chemisch analog zu Y³⁺-Komplexen und Sc³⁺-Komplexen.

Ausbeute und Reinheit von [(*i*PrCp)Lu(dbt)₂], welche gemäß diesem Beispiel erzielt werden, sind ähnlich oder identisch zu denjenigen, welche mittels den weiter oben für [(EtCp)₂Y(dbt)] (Beispiel 1.2) und für [(EtCp)₂Sc(dbt)] (Beispiel 3.2) beschriebenen Synthesen erhalten wurden.

### Beispiel 8: Darstellung von [(tBuCp)Er(dmt)(dpt)] ausgehend von [(tBuCp)ErCl₂]

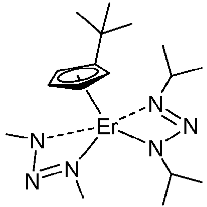

Zu 17,97 g [(*t*BuCp)ErCl₂] (50 mmol) in 150 mL n-Hexan werden bei 0 °C 3,95 g Li(dmt) (50 mmol) portionsweise über 2 Stunden gegeben. Anschließend werden bei 0 °C 6,76 g Li(dpt) (50 mmol) portionsweise über 2 Stunden zugegeben. Das Reaktionsgemisch wird für 2 Stunden bei 0 °C und danach für 16 Stunden bei Raumtemperatur gerührt. Anschließend wird das Reaktionsgemisch für 3 Stunden zum Sieden erhitzt. Die erhaltene Suspension wird filtriert und der Filterkuchen dreimal mit je 50 mL *n*-Hexan gewaschen. Das Lösungsmittel des Filtrats wird im Vakuum entfernt. [(tBuCp)Er(dmt)(dpt)] wird durch Destillation des Rückstands erhalten.

Aus der erfolgreichen Synthese gemäß Beispiel 1.2 und gemäß Beispiel 3.2 wird die Schlussfolgerung gezogen, dass eine Umsetzung von *tert*-Butylcyclopentadienyl-erbiumdichlorid [(*t*BuCp)ErCl₂] mit den Lithiumsalzen Li(dmt) und Li(dpt) - analog zu Beispiel 1.2 und Beispiel 3.2, wobei jedoch ein molares Verhältnis [(*t*BuCp)ErCl₂] : Lithiumsalze 1 : 2 beträgt, - die gewünschte Zielverbindung [(tBuCp)Er(dmt)(dpt)] zum Ergebnis hat.

Gemäß Beispiel 1.2 wurde ausgehend von [(EtCp)₂YCl] und Li(dbt), wobei ein molares Verhältnis der Edukte 1 : 1 betrug, die Verbindung [(EtCp)₂Y(dbt)] erhalten. Analog wurde gemäß Beispiel 3.2 ausgehend von [(EtCp)₂ScCl] und Li(dbt) der Komplex [(EtCp)₂Sc(dbt)] erhalten, und zwar in vergleichbarer Ausbeute und Reinheit wie der Komplex [(EtCp)₂Y(dbt)].

Wird anstelle von [(EtCp)₂YCl] oder [(EtCp)₂ScCl] der Erbium(III)-Komplex [(*t*BuCp)ErCl₂] - analog zu Beispiel 1.2 oder Beispiel 3.2, wobei jedoch ein molares Verhältnis [(*t*BuCp)ErCl₂] : Lithiumsalze 1 : 2 beträgt - mit Li(dmt) und Li(dpt) umgesetzt, wird [(*t*BuCp)Er(dmt)(dpt)] erhalten. Denn Lanthanoid(III)-Komplexe, wie beispielsweise der hier als Edukt vorgesehene Er³⁺-Komplex, verhalten sich chemisch analog zu Y³⁺-Komplexen und Sc³⁺-Komplexen.

Ausbeute und Reinheit von [(*t*BuCp)Er(dmt)(dpt)], welche gemäß diesem Beispiel erzielt werden, sind ähnlich oder identisch zu denjenigen, welche mittels den weiter oben für [(EtCp)₂Y(dbt)] (Beispiel 1.2) und für [(EtCp)₂Sc(dbt)] (Beispiel 3.2) beschriebenen Synthesen erhalten wurden.

### Beispiel 9: Darstellung von [(Et₂Cp)La(dbt)₂] ausgehend von [(Et₂Cp)LaCl₂]

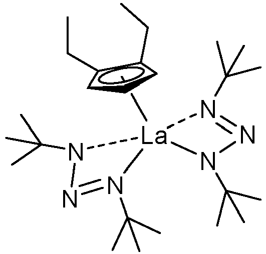

Zu 16,55 g [(Et₂Cp)LaCl₂] (50 mmol) in 200 mL *n*-Hexan werden bei 0 °C 16,32 g Li(dbt) (100 mmol) portionsweise über 2 Stunden gegeben. Das Reaktionsgemisch wird für 2 Stunden bei 0 °C und anschließend für 16 Stunden bei Raumtemperatur gerührt. Anschließend wird das Reaktionsgemisch für 3 Stunden zum Sieden erhitzt. Die erhaltene Suspension wird filtriert und der Filterkuchen dreimal mit je 50 mL n-Hexan gewaschen. Das Lösungsmittel des Filtrats wird im Vakuum entfernt. [(Et₂Cp)La(dbt)₂] wird durch Destillation des Rückstands erhalten.

Aus der erfolgreichen Synthese gemäß Beispiel 1.2 und gemäß Beispiel 3.2 wird die Schlussfolgerung gezogen, dass eine Umsetzung von Di-ethylcyclopentadienyl-lanthandichlorid [(Et₂Cp)LaCl₂] mit dem Lithiumsalzen Li(dbt) - analog zu Beispiel 1.2 und Beispiel 3.2, wobei jedoch ein molares Verhältnis [(Et₂Cp)LaCl₂] : Lithiumsalze 1 : 2 beträgt, - die gewünschte Zielverbindung [(Et₂Cp)La(dbt)₂] zum Ergebnis hat.

Gemäß Beispiel 1.2 wurde ausgehend von [(EtCp)₂YCl] und Li(dbt), wobei ein molares Verhältnis der Edukte 1 : 1 betrug, die Verbindung [(EtCp)₂Y(dbt)] erhalten. Analog wurde gemäß Beispiel 3.2 ausgehend von [(EtCp)₂ScCl] und Li(dbt) der Komplex [(EtCp)₂Sc(dbt)] erhalten, und zwar in vergleichbarer Ausbeute und Reinheit wie der Komplex [(EtCp)₂Y(dbt)].

Wird anstelle von [(EtCp)₂YCl] oder [(EtCp)₂ScCl] der Lanthan(III)-Komplex [(Et₂Cp)LaCl₂] - analog zu Beispiel 1.2 oder Beispiel 3.2, wobei jedoch ein molares Verhältnis [(Et₂Cp)LaCl₂] : Lithiumsalze 1 : 2 beträgt - mit Li(dbt) umgesetzt, wird [(Et₂Cp)La(dbt)₂] erhalten. Denn Lanthanoid(III)-Komplexe, wie beispielsweise der hier als Edukt vorgesehene La³⁺-Komplex, verhalten sich chemisch analog zu Y³⁺-Komplexen und Sc³⁺-Komplexen.

Ausbeute und Reinheit von [(Et₂Cp)La(dbt)₂], welche gemäß diesem Beispiel erzielt werden, sind ähnlich oder identisch zu denjenigen, welche mittels den weiter oben für [(EtCp)₂Y(dbt)] (Beispiel 1.2) und für [(EtCp)₂Sc(dbt)] (Beispiel 3.2) beschriebenen Synthesen erhalten wurden.

### Beispiel 10: Darstellung von [(Cp*)(MeCp)Ce(dmt)] ausgehend von [(Cp*)(MeCp)CeCl]

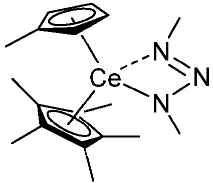

Zu 19,5 g [(Cp*)(MeCp)CeCl] (50 mmol) in 200 mL *n*-Hexan werden bei 0 °C 3,95 g Li(dmt) (50 mmol) portionsweise über 2 Stunden gegeben. Das Reaktionsgemisch wird für 2 Stunden bei 0 °C und anschließend für 16 Stunden bei Raumtemperatur gerührt. Anschließend wird das Reaktionsgemisch für 3 Stunden zum Sieden erhitzt. Die erhaltene Suspension wird filtriert und der Filterkuchen dreimal mit je 50 mL *n*-Hexan gewaschen. Das Lösungsmittel des Filtrats wird im Vakuum entfernt. [(Cp*)(MeCp)Ce(dmt)] wird durch Destillation des Rückstands erhalten.

Aus der erfolgreichen Synthese gemäß Beispiel 1.2 und gemäß Beispiel 3.2 wird die Schlussfolgerung gezogen, dass eine Umsetzung von [(Cp*)(MeCp)CeCl] mit Li(dmt) - analog zu Beispiel 1.2 und Beispiel 3.2 - die gewünschte Zielverbindung [(Cp*)(MeCp)Ce(dmt)] zum Ergebnis hat.

Gemäß Beispiel 1.2 wurde ausgehend von [(EtCp)₂YCl] und Li(dbt) die Verbindung [(EtCp)₂Y(dbt)] erhalten. Analog wurde gemäß Beispiel 3.2 ausgehend von [(EtCp)₂ScCl] und Li(dbt) der Komplex [(EtCp)₂Sc(dbt)] erhalten, und zwar in vergleichbarer Ausbeute und Reinheit wie der Komplex [(EtCp)₂Y(dbt)].

Wird anstelle von [(EtCp)₂YCl] oder [(EtCp)₂ScCl] der Cer(III)-Komplex [(Cp*)(MeCp)CeCl] - analog zu Beispiel 1.2 oder Beispiel 3.2 - mit Li(dmt) umgesetzt, wird [(Cp*)(MeCp)Ce(dmt)] erhalten. Denn Lanthanoid(III)-Komplexe, wie beispielsweise der hier als Edukt vorgesehene Ce³⁺-Komplex, verhalten sich chemisch analog zu Y³⁺-Komplexen und Sc³⁺-Komplexen.

Ausbeute und Reinheit von [(Cp*)(MeCp)Ce(dmt)], welche gemäß diesem Beispiel erzielt werden, sind ähnlich oder identisch zu denjenigen, welche mittels den weiter oben für [(EtCp)₂Y(dbt)] (Beispiel 1.2) und für [(EtCp)₂Sc(dbt)] (Beispiel 3.2) beschriebenen Synthesen erhalten wurden.

### Beispiel 11: Darstellung von [(iPrCp)(MeCp)Nd(dibt)] ausgehend von [(iPrCp)(MeCp)NdCl]

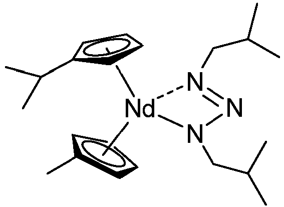

Zu 18,3 g [(*i*PrCp)(MeCp)NdCl] (50 mmol) in 200 mL *n*-Hexan werden bei 0 °C 8,16 g Li(dibt) (50 mmol) portionsweise über 2 Stunden gegeben. Das Reaktionsgemisch wird für 2 Stunden bei 0 °C und anschließend für 16 Stunden bei Raumtemperatur gerührt. Anschließend wird das Reaktionsgemisch für 3 Stunden zum Sieden erhitzt. Die erhaltene Suspension wird filtriert und der Filterkuchen dreimal mit je 50 mL *n*-Hexan gewaschen. Das Lösungsmittel des Filtrats wird im Vakuum entfernt. [(*i*PrCp)(MeCp)Nd(dibt)] wird durch Destillation des Rückstands erhalten.

Aus der erfolgreichen Synthese gemäß Beispiel 1.2 und gemäß Beispiel 3.2 wird die Schlussfolgerung gezogen, dass eine Umsetzung von [(*i*PrCp)(MeCp)NdCl] mit Li(dibt) - analog zu Beispiel 1.2 und Beispiel 3.2 - die gewünschte Zielverbindung [(*i*PrCp)(MeCp)Nd(dibt)] zum Ergebnis hat.

Gemäß Beispiel 1.2 wurde ausgehend von [(EtCp)₂YCl] und Li(dbt) die Verbindung [(EtCp)₂Y(dbt)] erhalten. Analog wurde gemäß Beispiel 3.2 ausgehend von [(EtCp)₂ScCl] und Li(dbt) der Komplex [(EtCp)₂Sc(dbt)] erhalten, und zwar in vergleichbarer Ausbeute und Reinheit wie der Komplex [(EtCp)₂Y(dbt)].

Wird anstelle von [(EtCp)₂YCl] oder [(EtCp)₂ScCl] der Cer(III)-Komplex [(*i*PrCp)(MeCp)NdCl] - analog zu Beispiel 1.2 oder Beispiel 3.2 - mit Li(dibt) umgesetzt, wird [(*i*PrCp)(MeCp)Nd(dibt)] erhalten. Denn Lanthanoid(III)-Komplexe, wie beispielsweise der hier als Edukt vorgesehene Nd³⁺-Komplex, verhalten sich chemisch analog zu Y³⁺-Komplexen und Sc³⁺-Komplexen.

Ausbeute und Reinheit von [(*i*PrCp)(MeCp)Nd(dibt)], welche gemäß diesem Beispiel erzielt werden, sind ähnlich oder identisch zu denjenigen, welche mittels den weiter oben für [(EtCp)₂Y(dbt)] (Beispiel 1.2) und für [(EtCp)₂Sc(dbt)] (Beispiel 3.2) beschriebenen Synthesen erhalten wurden.

Die Erfindung ist nicht auf eine der vorbeschriebenen Ausführungsformen beschränkt, sondern in vielfältiger Weise abwandelbar.

Man erkennt, dass die Erfindung Metallkomplexe gemäß der Formel [M(L_{C})(L_{T})(L_{Z})] betrifft. Dabei gilt: M = Scandium, Yttrium, Lanthanoid oder Titan; Lc = unsubstituiertes Cyclopentadienid-Anion, einfach alkylsubstituiertes oder mehrfach alkylsubstituiertes Cyclopentadienid-Anion; L_{T} = Triazenid-Anion (R¹-N₃-R²)⁻, wobei R¹ und R² unabhängig voneinander eine lineare Alkylgruppe mit 1 bis 10 Kohlenstoffatomen oder eine verzweigte Alkylgruppe mit 3 bis 10 Kohlenstoffatomen sind; Lz ist a) unabhängig von Lc ausgewählt aus der für Lc genannten Gruppe, oder b) unabhängig von L_{T} ausgewählt aus der für L_{T} genannten Gruppe.

Gegenstand der Erfindung ist zudem die Verwendung wenigstens eines solchen Metallkomplexes zur Herstellung einer Schicht, bestehend aus wenigstens einem Metall M oder enthaltend wenigstens ein Metall M, auf einer Oberfläche eines Substrats sowie zur Herstellung eines elektronischen Bauelements.

Die hier vorgestellten Metallkomplexe gemäß der allgemeinen Formel [M(L_{C})(L_{T})(L_{Z})] (I) sind auf einfache Weise hochrein in guten bis sehr guten Ausbeuten, auch im industriellen Maßstab, herstellbar. Überraschend und vorteilhaft ist, dass diese Verbindungen nach ihrer Isolierung und Reinigung mittels Destillation oder Sublimation solvensfrei vorliegen. Besonders vorteilhaft ist, dass das heteroleptische, variable Komplexdesign, welches wenigstens einen Liganden mit einem stickstoffbasierten, kohlenstofffreien Grundgerüst (Triazenid-Ligand) vorsieht, die Bereitstellung einer Vielzahl unterschiedlicher, insbesondere maßgeschneiderter beziehungsweise anwendungsspezifisch optimierter, Metallkomplexe ermöglicht. Dabei kann das hierin beschriebene Syntheseprotokoll vorteilhafterweise in der Regel ohne wesentliche Änderungen zur Herstellung einer, insbesondere für ein spezifisches Verfahren der chemischen Gasphasenabscheidung maßgeschneiderten, Verbindung des Typs [M(L_{C})(L_{T})(L_{Z})] (I) angewendet werden.

Ein weiterer wichtiger Vorteil der hier beschriebenen Metallkomplexe des Typs [M(L_{C})(L_{T})(L_{Z})] (I) besteht darin, dass sie sämtliche an Präkursormaterialien für chemische Gasphasenabscheidungsverfahren (CVD-Verfahren), beispielsweise MOCVD-Verfahren, MOVPE-Verfahren und ALD-Verfahren, gestellten Anforderungen genügen und somit insbesondere für den Einsatz in Verfahren dieser Art prädestiniert sind. Das Komplexdesign der Verbindungen gemäß Formel I fördert nicht nur in vorteilhafter Weise den Einbau gewünschter Elemente, nämlich des jeweiligen Metalls M sowie des Stickstoffs, in die zu erzeugende Schicht, sondern bedingt auch die Reduzierung des Einbaus unerwünschter Elemente, wie beispielsweise Kohlenstoff. Die Verwendung dieser Komplexe kann vorteilhafterweise unter idealen Prozesstemperaturen erfolgen, sodass qualitativ hochwertige Metallschichten und Metall enthaltende Schichten erzeugt werden können. Die erzeugten Schichten sind hinsichtlich ihrer Reinheit, ihrer Zusammensetzung und ihrer Morphologie qualitativ hochwertig. Insgesamt ist der Einsatz von Komplexen des hier vorgestellten Typs in chemischen Gasphasenabscheidungsverfahren aus (atom-)ökonomischer und ökologischer Sicht besonders vorteilhaft.

## Patentansprüche

1. Metallkomplex gemäß der allgemeinen Formel
[M(L_{C})(L_{T})(L_{Z})] (I),
wobei
i. M ein Metall-Zentralatom ist, ausgewählt aus der Gruppe bestehend aus Scandium (Sc), Yttrium (Y), Lanthanoiden und Titan (Ti),
ii. Lc ein monoanionischer pi-Donor-Ligand ist, ausgewählt aus der Gruppe bestehend aus
- unsubstituiertem Cyclopentadienid-Anion,
- einfach alkylsubstituierten Cyclopentadienid-Anionen gemäß der allgemeinen Formel R^{A}Cp⁻, wobei
R^{A} ausgewählt ist aus der Gruppe bestehend aus linearen Alkylgruppen mit 1 bis 10 Kohlenstoffatomen und verzweigten Alkylgruppen mit 3 bis 10 Kohlenstoffatomen, und
- mehrfach alkylsubstituierten Cyclopentadienid-Anionen gemäß der allgemeinen Formel R^{B}R^{C}R^{D}R^{E}R^{F}Cp⁻, wobei
die Reste R^{B}, R^{C}, R^{D}, R^{E} und R^{F} unabhängig voneinander ausgewählt sind aus der Gruppe bestehend aus Wasserstoff (H), linearen Alkylgruppen mit 1 bis 10 Kohlenstoffatomen und verzweigten Alkylgruppen mit 3 bis 10 Kohlenstoffatomen,
mit der Maßgabe, dass wenigstens zwei der Reste R^{B}, R^{C}, R^{D}, R^{E} und R^{F} ungleich Wasserstoff (H) sind;
iii. L_{T} ein Triazenid-Anion gemäß der allgemeinen Formel (R¹-N₃-R²)⁻ ist, wobei die Reste R¹ und R² unabhängig voneinander ausgewählt sind aus der Gruppe bestehend aus linearen Alkylgruppen mit 1 bis 10 Kohlenstoffatomen und verzweigten Alkylgruppen mit 3 bis 10 Kohlenstoffatomen;
und
iv. Lz ein
a) monoanionischer pi-Donor-Ligand ist, welcher unabhängig von dem monoanionischen pi-Donor-Liganden L_{C} ausgewählt ist aus der Gruppe bestehend aus
- unsubstituiertem Cyclopentadienid-Anion (C₅H₅⁻),
- einfach alkylsubstituierten Cyclopentadienid-Anionen gemäß der allgemeinen Formel R^{A}Cp⁻, wobei
R^{A} ausgewählt ist aus der Gruppe bestehend aus linearen Alkylgruppen mit 1 bis 10 Kohlenstoffatomen und verzweigten Alkylgruppen mit 3 bis 10 Kohlenstoffatomen, und
- mehrfach alkylsubstituierten Cyclopentadienid-Anionen gemäß der allgemeinen Formel R^{B}R^{C}R^{D}R^{E}R^{F}Cp⁻, wobei
die Reste R^{B}, R^{C}, R^{D}, R^{E} und R^{F} unabhängig voneinander ausgewählt sind aus der Gruppe bestehend aus Wasserstoff (H), linearen Alkylgruppen mit 1 bis 10 Kohlenstoffatomen und verzweigten Alkylgruppen mit 3 bis 10 Kohlenstoffatomen,
mit der Maßgabe, dass wenigstens zwei der Reste R^{B}, R^{C}, R^{D}, R^{E} und R^{F} ungleich Wasserstoff (H) sind;
oder
b) Triazenid-Anion gemäß der allgemeinen Formel (R¹-N₃-R²)⁻ ist, wobei die Reste R¹ und R² unabhängig voneinander und unabhängig von dem Triazenid-Anion L_{T} ausgewählt sind aus der Gruppe bestehend aus linearen Alkylgruppen mit 1 bis 10 Kohlenstoffatomen und verzweigten Alkylgruppen mit 3 bis 10 Kohlenstoffatomen.

2. Metallkomplex nach Anspruch 1, wobei das Lanthanoid ausgewählt ist aus der Gruppe bestehend aus
i. La, Ce, Pr, Nd, Sm, Eu, Gd, Tb, Dy, Ho, Er, Tm, Yb und Lu;
oder
ii. La, Ce, Pr, Nd, Sm, Eu, Gd, Tb, Er, Yb und Lu;
oder
iii. La, Ce, Pr, Nd, Eu, Gd, Er, Yb und Lu;
oder
iv. La, Ce, Nd, Eu, Er und Lu.

3. Metallkomplex nach Anspruch 1 oder Anspruch 2, wobei
i. der monoanionische pi-Donor-Ligand Lc ausgewählt ist aus der Gruppe bestehend aus
- unsubstituiertem Cyclopentadienid-Anion (C₅H₅⁻);
- einfach alkylsubstituierten Cyclopentadienid-Anionen gemäß der allgemeinen Formel R^{A}Cp⁻, wobei
der Rest R^{A} ausgewählt ist aus der Gruppe bestehend aus Methyl, Ethyl, Propyl, Butyl, Pentyl, und deren Isomeren;
- mehrfach alkylsubstituierten Cyclopentadienid-Anionen gemäß der allgemeinen Formel R^{B}R^{C}R^{D}R^{E}R^{F}Cp⁻, wobei
die Reste R^{B}, R^{C}, R^{D}, R^{E} und R^{F} unabhängig voneinander ausgewählt sind aus der Gruppe bestehend aus Wasserstoff (H), Methyl, Ethyl, Propyl, Butyl, Pentyl, und deren Isomeren,
mit der Maßgabe, dass wenigstens zwei der Reste R^{B}, R^{C}, R^{D}, R^{E} und R^{F} ungleich Wasserstoff (H) sind;
und/oder
ii. wenigstens einer der Reste R¹ und R² des Triazenid-Anions L_{T} ausgewählt ist aus der Gruppe bestehend aus linearen Alkylgruppen mit 1 bis 6 Kohlenstoffatomen und verzweigten Alkylgruppen mit 3 bis 6 Kohlenstoffatomen.

4. Metallkomplex nach wenigstens einem der Ansprüche 1 bis 3, wobei der Ligand Lz
a) ein monoanionischer pi-Donor-Ligand ist, wobei der monoanionische pi-Donor-Ligand Lz ausgewählt ist aus der Gruppe bestehend aus
- unsubstituiertem Cyclopentadienid-Anion (C₅H₅⁻);
- einfach alkylsubstituierten Cyclopentadienid-Anionen gemäß der allgemeinen Formel R^{A}Cp⁻, wobei der Rest R^{A} ausgewählt ist aus der Gruppe bestehend aus Methyl, Ethyl, Propyl, Butyl, Pentyl, und deren Isomeren;
- mehrfach alkylsubstituierten Cyclopentadienid-Anionen gemäß der allgemeinen Formel R^{B}R^{C}R^{D}R^{E}R^{F}Cp⁻, wobei die Reste R^{B}, R^{C}, R^{D}, R^{E} und R^{F} unabhängig voneinander ausgewählt sind aus der Gruppe bestehend aus Wasserstoff (H), Methyl, Ethyl, Propyl, Butyl, Pentyl, und deren Isomeren,
mit der Maßgabe, dass wenigstens zwei der Reste R^{B}, R^{C}, R^{D}, R^{E} und R^{F} ungleich Wasserstoff (H) sind;
oder
b) ein Triazenid-Anion gemäß der allgemeinen Formel (R¹-N₃-R²)⁻ ist, wobei wenigstens einer der Reste R¹ und R² des Triazenid-Anions Lz ausgewählt ist aus der Gruppe bestehend aus linearen Alkylgruppen mit 1 bis 6 Kohlenstoffatomen und verzweigten Alkylgruppen mit 3 bis 6 Kohlenstoffatomen.

5. Metallkomplex nach einem oder mehreren der vorhergehenden Ansprüche, wobei der Metallkomplex eine oder mehrere der folgenden Eigenschaften aufweist:
i. der Rest R¹ und der Rest R² des Triazenid-Anions L_{T} sind unabhängig voneinander ausgewählt aus der Gruppe bestehend aus Methyl, Ethyl, Propyl, Butyl, Pentyl, und deren Isomeren;
ii. der Rest R¹ und der Rest R² des Triazenid-Anions L_{T} sind identisch;
iii. Lz ist ein monoanionischer pi-Donor-Ligand, wobei der monoanionische pi-Donor-Ligand Lc und der monoanionische pi-Donor-Ligand Lz identisch sind;
iv. Lz ist ein Triazenid-Anion gemäß der allgemeinen Formel (R¹-N₃-R²)⁻, wobei der Rest R¹ und der Rest R² des Triazenid-Anions Lz unabhängig voneinander ausgewählt sind aus der Gruppe bestehend aus Methyl, Ethyl, Propyl, Butyl, Pentyl, und deren Isomeren;
v. Lz ist ein Triazenid-Anion gemäß der allgemeinen Formel (R¹-N₃-R²)⁻, wobei der Rest R¹ und der Rest R² des Triazenid-Anions Lz identisch sind;
vi. Lz ist ein Triazenid-Anion gemäß der allgemeinen Formel (R¹-N₃-R²)⁻, wobei das Triazenid-Anion L_{T} und das Triazenid-Anion L_{Z} identisch sind.

6. Metallkomplex nach einem oder mehreren der vorhergehenden Ansprüche, wobei das Metall-Zentralatom M ausgewählt ist aus der Gruppe bestehend aus Sc, Y, La, Ce, Nd, Eu, Er, Lu und Ti, und
A. der Ligand Lz ein monoanionischer pi-Donor-Ligand ist, wobei
i. der monoanionische pi-Donor-Ligand Lc oder der monoanionische pi-Donor-Ligand Lz ausgewählt ist
oder
ii. der monoanionische pi-Donor-Ligand Lc und der monoanionische pi-Donor-Ligand Lz unabhängig voneinander ausgewählt sind
aus der Gruppe bestehend aus
- unsubstituiertem Cyclopentadienid-Anion (C₅H₅⁻);
- einfach alkylsubstituierten Cyclopentadienid-Anionen gemäß der allgemeinen Formel R^{A}Cp⁻, wobei
der Rest R^{A} ausgewählt ist aus der Gruppe bestehend aus Methyl, Ethyl, *n*-Propyl, *iso*-Propyl, *n*-Butyl, *iso*-Butyl, *sec*-Butyl und *tert-*Butyl;
- mehrfach alkylsubstituierten Cyclopentadienid-Anionen gemäß der allgemeinen Formel R^{B}R^{C}R^{D}R^{E}R^{F}Cp⁻, wobei
die Reste R^{B}, R^{C}, R^{D}, R^{E} und R^{F} unabhängig voneinander ausgewählt sind aus der Gruppe bestehend aus Wasserstoff (H), Methyl, Ethyl, *n*-Propyl, *iso*-Propyl, *n*-Butyl, *iso*-Butyl, *sec*-Butyl und *tert*-Butyl,
mit der Maßgabe, dass wenigstens zwei der Reste R^{B}, R^{C}, R^{D}, R^{E} und R^{F}, welche ungleich Wasserstoff (H) sind, identisch sind;
und
der Rest R¹ und der Rest R² des Triazenid-Anions L_{T} unabhängig voneinander ausgewählt sind aus der Gruppe bestehend aus Methyl, Ethyl, *iso*-Propyl, *iso*-Butyl, *sec*-Butyl und *tert*-Butyl;
oder
B. der Ligand Lz ein Triazenid-Anion gemäß der allgemeinen Formel (R¹-N₃-R²)⁻ ist, wobei
i. die Reste R¹ und R² eines der beiden Triazenid-Anionen L_{T} und Lz unabhängig voneinander ausgewählt sind aus der Gruppe bestehend aus Methyl, Ethyl, *iso*-Propyl, *iso*-Butyl, *sec*-Butyl und *tert*-Butyl,
oder
ii. die Reste R¹ und R² des Triazenid-Anions L_{T} und die Reste R¹ und R² des Triazenid-Anions Lz jeweils unabhängig voneinander ausgewählt sind aus der Gruppe bestehend aus Methyl, Ethyl, *iso-*Propyl, *iso*-Butyl, *sec*-Butyl und *tert*-Butyl;
und
der monoanionische pi-Donor-Ligand Lc ausgewählt ist aus der Gruppe bestehend aus
- unsubstituiertem Cyclopentadienid-Anion (C₅H₅⁻);
- einfach alkylsubstituierten Cyclopentadienid-Anionen gemäß der allgemeinen Formel R^{A}Cp⁻, wobei
der Rest R^{A} ausgewählt ist aus der Gruppe bestehend aus Methyl, Ethyl, *n*-Propyl, *iso*-Propyl, *n*-Butyl, *iso*-Butyl, *sec*-Butyl und *tert-*Butyl;
- mehrfach alkylsubstituierten Cyclopentadienid-Anionen gemäß der allgemeinen Formel R^{B}R^{C}R^{D}R^{E}R^{F}Cp⁻, wobei
die Reste R^{B}, R^{C}, R^{D}, R^{E} und R^{F} unabhängig voneinander ausgewählt sind aus der Gruppe bestehend aus Wasserstoff (H), Methyl, Ethyl, *n*-Propyl, *iso*-Propyl, *n*-Butyl, *iso*-Butyl, *sec*-Butyl und *tert*-Butyl,
mit der Maßgabe, dass wenigstens zwei der Reste R^{B}, R^{C}, R^{D}, R^{E} und R^{F}, welche ungleich Wasserstoff (H) sind, identisch sind.

7. Metallkomplex nach einem oder mehreren der vorhergehenden Ansprüche, wobei der Metallkomplex die Formel I.1 oder die Formel I.2 oder die Formel I.3 oder die Formel I.4 oder die Formel I.5 oder die Formel I.6 oder die Formel I.7 oder die Formel I.8 oder die Formel I.9 oder die Formel I.10 oder die Formel I.11 aufweist:

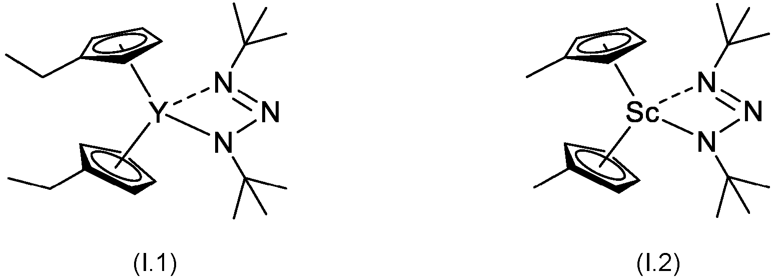

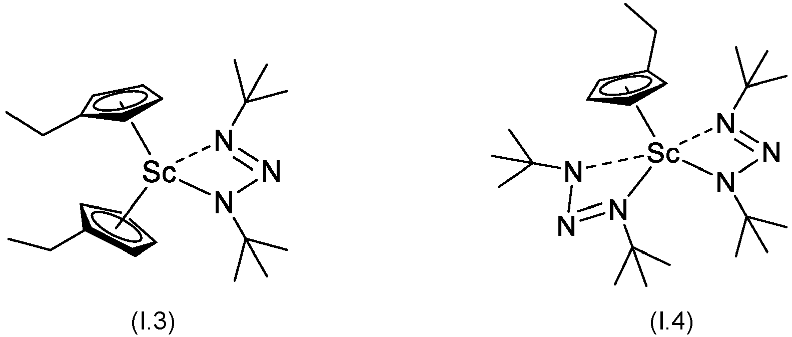

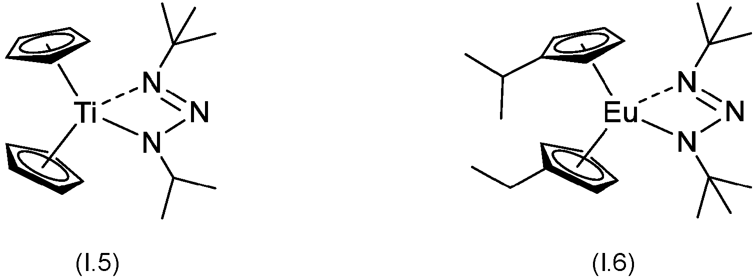

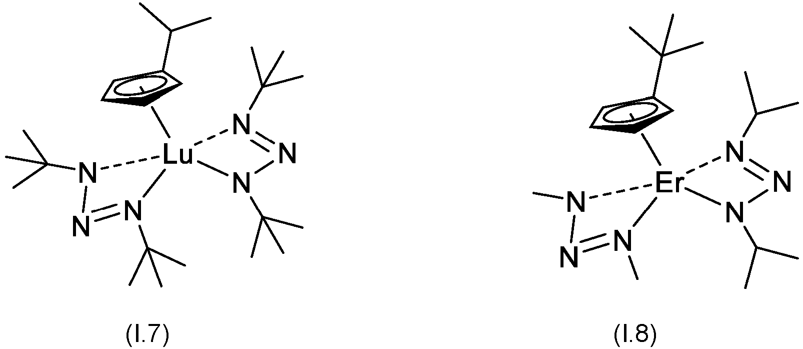

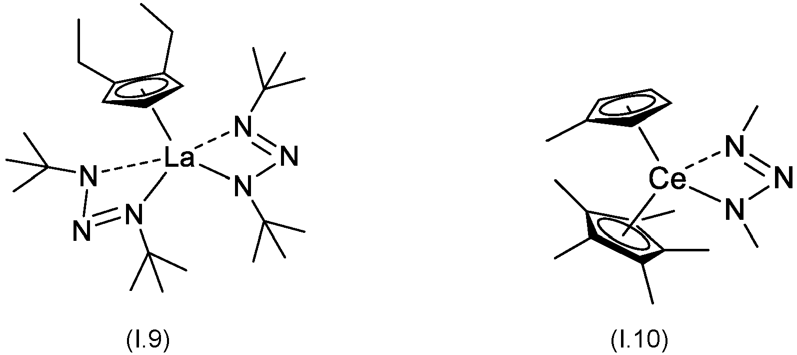

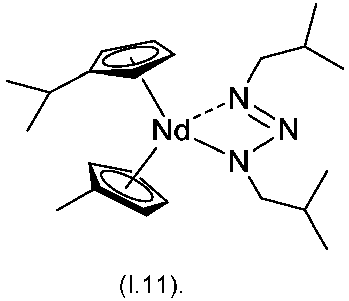

8. Metallkomplex nach einem oder mehreren der vorhergehenden Ansprüche, wobei
i. der Metallkomplex zersetzungsfrei verdampfbar ist oder zersetzungsfrei sublimierbar ist,
und/oder
ii. ein Molekulargewicht des Metallkomplexes weniger als 600 g/mol beträgt.

9. Verfahren zur Herstellung einer Schicht, welche
i. aus wenigstens einem Metall M besteht,
wobei das wenigstens eine Metall M ausgewählt ist aus der Gruppe bestehend aus Scandium, Yttrium, Lanthanoiden und Titan,
oder
ii. wenigstens ein Metall M enthält,
wobei das wenigstens eine Metall M ausgewählt ist aus der Gruppe bestehend aus Scandium, Yttrium, Lanthanoiden und Titan,
auf einer Oberfläche eines Substrats, insbesondere eines Halbleitersubstrats,
unter Verwendung
- wenigstens eines Metallkomplexes gemäß der allgemeinen Formel [M(L_{C})(L_{T})(L_{Z})] (I) nach einem oder mehreren der Ansprüche 1 bis 8,
oder
- einer Lösung, umfassend wenigstens einen Metallkomplex gemäß der allgemeinen Formel [M(L_{C})(L_{T})(L_{Z})] (I) nach einem oder mehreren der Ansprüche 1 bis 8 und ein aprotisch-unpolares Lösungsmittel,
umfassend die folgenden Schritte:
A. Zurverfügungstellung
- des wenigstens einen Metallkomplexes gemäß der allgemeinen Formel [M(L_{C})(L_{T})(L_{Z})] (I) nach einem oder mehreren der Ansprüche 1 bis 8,
oder
- der Lösung, umfassend wenigstens einen Metallkomplex gemäß der allgemeinen Formel [M(L_{C})(L_{T})(L_{Z})] (I) nach einem oder mehreren der Ansprüche 1 bis 8 und ein aprotisch-unpolares Lösungsmittel,
und
B. Abscheidung der Schicht, welche
i. aus dem wenigstens einen Metall M besteht,
oder
ii. das wenigstens eine Metall M enthält,
auf der Oberfläche des Substrats unter Verwendung des in Schritt A. zur Verfügung gestellten wenigstens einen Metallkomplexes als Präkursorverbindung.

10. Verfahren zur Herstellung eines elektronischen Bauelements, insbesondere eines elektronischen Halbleiterbauelements, unter Verwendung
- wenigstens eines Metallkomplexes gemäß der allgemeinen Formel [M(L_{C})(L_{T})(L_{Z})] (I) nach einem oder mehreren der Ansprüche 1 bis 8,
oder
- einer Lösung, umfassend wenigstens einen Metallkomplex gemäß der allgemeinen Formel [M(L_{C})(L_{T})(L_{Z})] (I) nach einem oder mehreren der Ansprüche 1 bis 8 und ein aprotisch-unpolares Lösungsmittel,
umfassend die folgenden Schritte:
A. Zurverfügungstellung
- des wenigstens einen Metallkomplexes gemäß der allgemeinen Formel [M(L_{C})(L_{T})(L_{Z})] (I) nach einem oder mehreren der Ansprüche 1 bis 8,
oder
- der Lösung, umfassend wenigstens einen Metallkomplex gemäß der allgemeinen Formel [M(L_{C})(L_{T})(L_{Z})] (I) nach einem oder mehreren der Ansprüche 1 bis 8 und ein aprotisch-unpolares Lösungsmittel,
B. Abscheidung einer Schicht, welche
i. aus dem wenigstens einen Metall M besteht,
oder
ii. das wenigstens eine Metall M enthält,
auf einer Oberfläche eines Substrats,
und
C. Fertigstellung des elektronischen Bauelements, insbesondere des elektronischen Halbleiterbauelements.

## Claims

1. Metal complex according to the general formula
[M(L_{C})(L_{T})(L_{Z})] (I),
wherein
i. M is a metal central atom selected from the group consisting of scandium (Sc), yttrium (Y), lanthanides and titanium (Ti),
ii. Lc is a monoanionic pi-donor ligand selected from the group consisting of
- unsubstituted cyclopentadienide anion,
- monoalkyl-substituted cyclopentadienide anions according to the general formula R^{A}Cp⁻, wherein
R^{A} is selected from the group consisting of linear alkyl groups with 1 to 10 carbon atoms and branched alkyl groups with 3 to 10 carbon atoms, and
- polyalkyl-substituted cyclopentadienide anions according to the general formula R^{B}R^{C}R^{D}R^{E}R^{F}Cp⁻, wherein
the radicals R^{B}, R^{C}, R^{D}, R^{E} and R^{F} are independently of each other selected from the group consisting of hydrogen (H), linear alkyl groups with 1 to 10 carbon atoms and branched alkyl groups with 3 to 10 carbon atoms,
with the proviso that at least two of the radicals R^{B}, R^{C}, R^{D}, R^{E} and R^{F} are unequal hydrogen (H);
iii. L_{T} is a triazenide anion according to the general formula (R¹-N₃-R²)⁻, wherein the radicals R¹ and R² are independently of each other selected from the group consisting of linear alkyl groups with 1 to 10 carbon atoms and branched alkyl groups with 3 to 10 carbon atoms;
and
iv. Lz is a
a) monoanionic pi-donor ligand which is, independently of the monoanionic pi-donor ligand Lc, selected from the group consisting of
- unsubstituted cyclopentadienide anion (C₅H₅⁻),
- monoalkyl-substituted cyclopentadienide anions according to the general formula R^{A}Cp⁻, wherein
R^{A} is selected from the group consisting of linear alkyl groups with 1 to 10 carbon atoms and branched alkyl groups with 3 to 10 carbon atoms, and
- polyalkyl-substituted cyclopentadienide anions according to the general formula R^{B}R^{C}R^{D}R^{E}R^{F}Cp⁻, wherein
the radicals R^{B}, R^{C}, R^{D}, R^{E} and R^{F} are independently of each other selected from the group consisting of hydrogen (H), linear alkyl groups with 1 to 10 carbon atoms and branched alkyl groups with 3 to 10 carbon atoms,
with the proviso that at least two of the radicals R^{B}, R^{C}, R^{D}, R^{E} and R^{F} are unequal hydrogen (H);
or
b) triazenide anion according to the general formula (R¹-N₃-R²)⁻,
wherein the radicals R¹ and R² are independently of each other and independently of the triazenide anion L_{T} selected from the group consisting of linear alkyl groups with 1 to 10 carbon atoms and branched alkyl groups with 3 to 10 carbon atoms.

2. Metal complex according to claim 1, wherein the lanthanide is selected from the group consisting of
i. La, Ce, Pr, Nd, Sm, Eu, Gd, Tb, Dy, Ho, Er, Tm, Yb and Lu;
or
ii. La, Ce, Pr, Nd, Sm, Eu, Gd, Tb, Er, Yb and Lu;
or
iii. La, Ce, Pr, Nd, Eu, Gd, Er, Yb and Lu;
or
iv. La, Ce, Nd, Eu, Er and Lu.

3. Metal complex according to claim 1 or claim 2, wherein
i. the monoanionic pi-donor ligand Lc is selected from the group consisting of
- unsubstituted cyclopentadienide anion (C₅H₅⁻);
- monoalkyl-substituted cyclopentadienide anions according to the general formula R^{A}Cp⁻, wherein
the radical R^{A} is selected from the group consisting of methyl, ethyl, propyl, butyl, pentyl, and their isomers;
- polyalkyl-substituted cyclopentadienide anions according to the general formula R^{B}R^{C}R^{D}R^{E}R^{F}Cp⁻, wherein
the radicals R^{B}, R^{C}, R^{D}, R^{E} and R^{F} are independently of each other selected from the group consisting of hydrogen (H), methyl, ethyl, propyl, butyl, pentyl, and their isomers,
with the proviso that at least two of the radicals R^{B}, R^{C}, R^{D}, R^{E} and R^{F} are unequal hydrogen (H);
and/or
ii. at least one of the radicals R¹ and R² of the triazenide anion L_{T} is selected from the group consisting of linear alkyl groups with 1 to 6 carbon atoms and branched alkyl groups with 3 to 6 carbon atoms.

4. Metal complex according to at least one of claims 1 to 3, wherein the ligand L_{Z}
a) is a monoanionic pi-donor ligand, wherein the monoanionic pi-donor ligand Lz is selected from the group consisting of
- unsubstituted cyclopentadienide anion (C₅H₅⁻);
- monoalkyl-substituted cyclopentadienide anions according to the general formula R^{A}Cp⁻, wherein the radical R^{A} is selected from the group consisting of methyl, ethyl, propyl, butyl, pentyl, and their isomers;
- polyalkyl-substituted cyclopentadienide anions according to the general formula R^{B}R^{C}R^{D}R^{E}R^{F}Cp⁻, wherein the radicals R^{B}, R^{C}, R^{D}, R^{E} and R^{F} are independently of each other selected from the group consisting of hydrogen (H), methyl, ethyl, propyl, butyl, pentyl, and their isomers,
with the proviso that at least two of the radicals R^{B}, R^{C}, R^{D}, R^{E} and R^{F} are unequal hydrogen (H);
or
b) is a triazenide anion according to the general formula (R¹-N₃-R²)⁻,
wherein at least one of the radicals R¹ and R² of the triazenide anion Lz is selected from the group consisting of linear alkyl groups with 1 to 6 carbon atoms and branched alkyl groups with 3 to 6 carbon atoms.

5. Metal complex according to one or more of the preceding claims, wherein the metal complex exhibits one or more of the following properties:
i. the radical R¹ and the radical R² of the triazenide anion L_{T} are independently of each other selected from the group consisting of methyl, ethyl, propyl, butyl, pentyl, and their isomers;
ii. the radical R¹ and the radical R² of the triazenide anion L_{T} are identical;
iii. Lz is a monoanionic pi-donor ligand, wherein the monoanionic pi-donor ligand Lc and the monoanionic pi-donor ligand Lz are identical;
iv. L_{Z} is a triazenide anion according to the general formula (R¹-N₃-R²)⁻, wherein the radical R¹ and the radical R² of the triazenide anion Lz are independently of each other selected from the group consisting of methyl, ethyl, propyl, butyl, pentyl, and their isomers;
v. Lz is a triazenide anion according to the general formula (R¹-N₃-R²)⁻, wherein the radical R¹ and the radical R² of the triazenide anion Lz are identical;
vi. Lz is a triazenide anion according to the general formula (R¹-N₃-R²)⁻, wherein the triazenide anion L_{T} and the triazenide anion Lz are identical.

6. Metal complex according to one or more of the preceding claims, wherein the metal central atom M is selected from the group consisting of Sc, Y, La, Ce, Nd, Eu, Er, Lu and Ti, and
A. the ligand Lz is a monoanionic pi-donor ligand, wherein
i. the monoanionic pi-donor ligand Lc or the monoanionic pi-donor ligand Lz is selected
or
ii. the monoanionic pi-donor ligand Lc and the monoanionic pi-donor ligand Lz are independently of each other selected
from the group consisting of
- unsubstituted cyclopentadienide anion (C₅H₅⁻);
- monoalkyl-substituted cyclopentadienide anions according to the general formula R^{A}Cp⁻, wherein
the radical R^{A} is selected from the group consisting of methyl, ethyl, *n*-propyl, *iso*-propyl, *n*-butyl, *iso*-butyl, *sec*-butyl and *tert*-butyl;
- polyalkyl-substituted cyclopentadienide anions according to the general formula R^{B}R^{C}R^{D}R^{E}R^{F}Cp⁻, wherein
the radicals R^{B}, R^{C}, R^{D}, R^{E} and R^{F} are independently of each other selected from the group consisting of hydrogen (H), methyl, ethyl, *n-*propyl, *iso*-propyl, *n*-butyl, *iso*-butyl, *sec*-butyl and *tert*-butyl,
with the proviso that at least two of the radicals R^{B}, R^{C}, R^{D}, R^{E} and R^{F}, which are unequal hydrogen (H), are identical;
and
the radical R¹ and the radical R² of the triazenide anion L_{T} are independently of each other selected from the group consisting of methyl, ethyl, *iso*-propyl, *iso*-butyl, *sec*-butyl and *tert*-butyl;
or
B. the ligand Lz is a triazenide anion according to the general formula (R¹-N₃-R²)-, wherein
i. the radicals R¹ and R² of one of the two triazenide anions L_{T} and Lz are independently of each other selected from the group consisting of methyl, ethyl, *iso*-propyl, *iso*-butyl, *sec*-butyl and *tert*-butyl,
or
ii. the radicals R¹ and R² of the triazenide anion L_{T} and the radicals R¹ and R² of the triazenide anion Lz are each independently of each other selected from the group consisting of methyl, ethyl, *iso*-propyl, *iso*-butyl, *sec*-butyl and *tert*-butyl;
and
the monoanionic pi-donor ligand Lc is selected from the group consisting of
- unsubstituted cyclopentadienide anion (C₅H₅⁻);
- monoalkyl-substituted cyclopentadienide anions according to the general formula R^{A}Cp⁻, wherein
the radical R^{A} is selected from the group consisting of methyl, ethyl, *n*-propyl, *iso*-propyl, *n*-butyl, *iso*-butyl, *sec*-butyl and *tert*-butyl;
- polyalkyl-substituted cyclopentadienide anions according to the general formula R^{B}R^{C}R^{D}R^{E}R^{F}Cp⁻, wherein
the radicals R^{B}, R^{C}, R^{D}, R^{E} and R^{F} are independently of each other selected from the group consisting of hydrogen (H), methyl, ethyl, n-propyl, *iso*-propyl, *n*-butyl, *iso*-butyl, *sec*-butyl and *tert*-butyl,
with the proviso that at least two of the radicals R^{B}, R^{C}, R^{D}, R^{E} and R^{F}, which are unequal hydrogen (H), are identical.

7. Metal complex according to one or more of the preceding claims, wherein the metal complex exhibits the formula I.1 or the formula I.2 or the formula I.3 or the formula I.4 or the formula I.5 or the formula I.6 or the formula I.7 or the formula I.8 or the formula I.9 or the formula I.10 or the formula I.11:

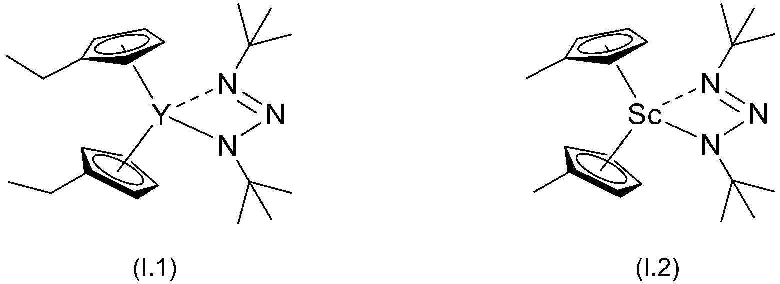

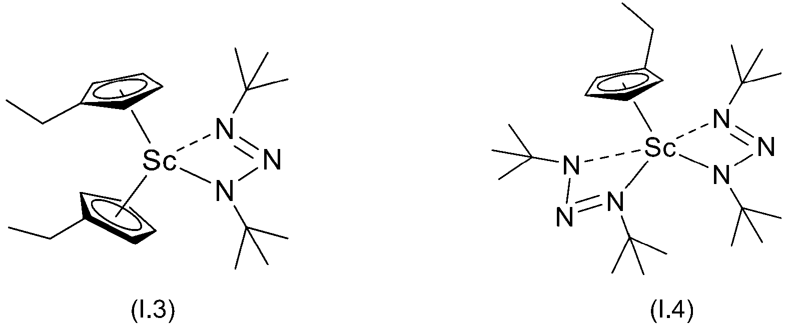

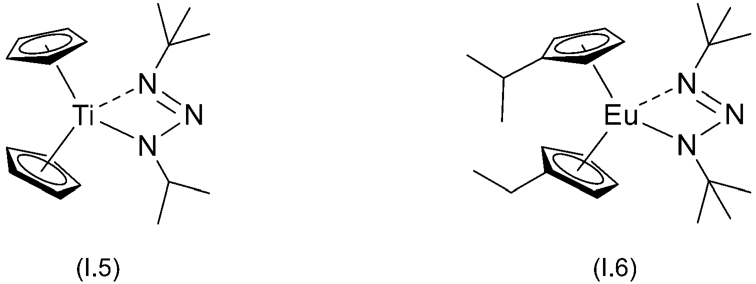

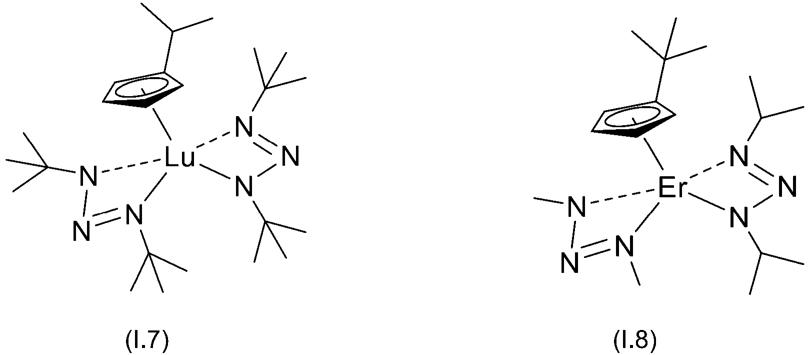

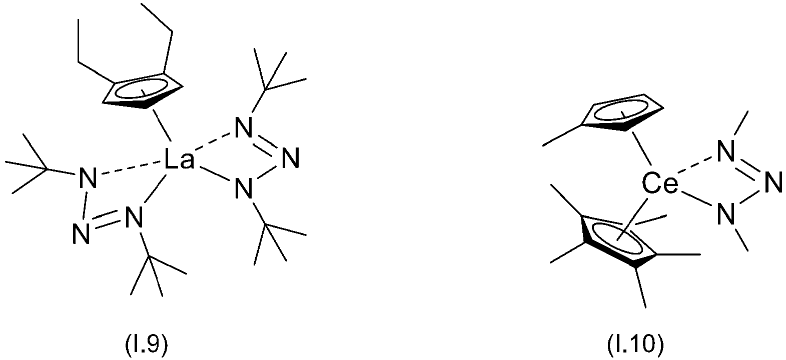

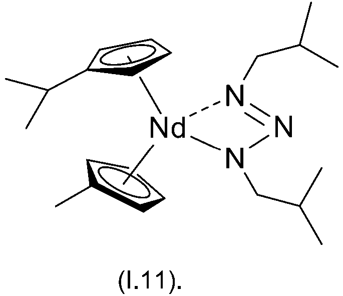

8. Metal complex according to one or more of the preceding claims, wherein
i. the metal complex is vaporisable without decomposition or sublimable without decomposition,
and/or
ii. a molecular weight of the metal complex is less than 600 g/mol.

9. Method for producing a layer which
i. consists of at least one metal M,
wherein the at least one metal M is selected from the group consisting of scandium, yttrium, lanthanides and titanium,
or
ii. contains at least one metal M,
wherein the at least one metal M is selected from the group consisting of scandium, yttrium, lanthanides and titanium,
on a surface of a substrate, in particular of a semiconductor substrate, using
- at least one metal complex according to the general formula [M(L_{C})(L_{T})(L_{Z})] (I) according to one or more of claims 1 to 8,
or
- a solution comprising at least one metal complex according to the general formula [M(L_{C})(L_{T})(L_{Z})] (I) according to one or more of claims 1 to 8 and an aprotic non-polar solvent,
comprising the following steps:
A. provision
- of the at least one metal complex according to the general formula [M(L_{C})(L_{T})(L_{Z})] (I) according to one or more of claims 1 to 8,
or
- of the solution comprising at least one metal complex according to the general formula [M(L_{C})(L_{T})(L_{Z})] (I) according to one or more of claims 1 to 8 and an aprotic non-polar solvent,
and
B. deposition of the layer which
i. consists of the at least one metal M,
or
ii. contains the at least one metal M,
on the surface of the substrate using the at least one metal complex provided in step A. as precursor compound.

10. Method for producing an electronic component, in particular an electronic semiconductor component, using
- at least one metal complex according to the general formula [M(L_{C})(L_{T})(L_{Z})] (I) according to one or more of claims 1 to 8,
or
- a solution comprising at least one metal complex according to the general formula [M(L_{C})(L_{T})(L_{Z})] (I) according to one or more of claims 1 to 8 and an aprotic non-polar solvent,
comprising the following steps:
A. provision
- of the at least one metal complex according to the general formula [M(L_{C})(L_{T})(L_{Z})] (I) according to one or more of claims 1 to 8,
or
- of the solution comprising at least one metal complex according to the general formula [M(L_{C})(L_{T})(L_{Z})] (I) according to one or more of claims 1 to 8 and an aprotic non-polar solvent,
B. deposition of a layer which
i. consists of the at least one metal M,
or
ii. contains the at least one metal M,
on a surface of a substrate,
and
C. completion of the electronic component, in particular the electronic semiconductor component.

## Revendications

1. Complexe de métal selon la formule générale
[M(L_{C})(L_{T})(L_{Z})] (I),
dans laquelle
i. M est un atome central métallique, choisi dans le groupe constitué de scandium (Sc), d'yttrium (Y), de lanthanoïdes et de titane (Ti),
ii. Lc est un ligand donneur de pi de type monoanionique, choisi dans le groupe constitué
- de l'anion cyclopentadiénide non substitué,
- des anions cyclopentadiénide monosubstitués à l'alkyle répondant à la formule générale R^{A}Cp⁻, dans laquelle
R^{A} est choisi dans le groupe constitué de groupements alkyle linéaires renfermant 1 à 10 atomes de carbone et de groupements alkyle ramifiés renfermant 3 à 10 atomes de carbone, et
- des anions cyclopentadiénide polysubstitués à l'alkyle répondant à la formule générale R^{B}R^{C}R^{D}R^{E}R^{F}Cp⁻,
les radicaux R^{B}, R^{C}, R^{D}, R^{E} et R^{F} étant choisis, indépendamment les uns des autres, dans le groupe constitué d'hydrogène (H), de groupements alkyle linéaires renfermant 1 à 10 atomes de carbone et de groupements alkyle ramifiés renfermant 3 à 10 atomes de carbone,
à condition qu'au moins deux des radicaux R^{B}, R^{C}, R^{D}, R^{E} et R^{F} ne représentent pas l'hydrogène (H);
iii. L_{T} est un anion triazénide répondant à la formule générale (R¹-N₃-R²)-, les radicaux R¹ et R² étant choisis, indépendamment l'un de l'autre, dans le groupe constitué de groupements alkyle linéaires renfermant 1 à 10 atomes de carbone et de groupements alkyle ramifiés renfermant 3 à 10 atomes de carbone;
et
iv. Lz représente
a) un ligand donneur de pi de type monoanionique qui est choisi, de manière indépendante du ligand donneur de pi de type monoanionique Lc, dans le groupe constitué
- de l'anion cyclopentadiénide non substitué (C₅H₅⁻),
- des anions cyclopentadiénide monosubstitués à l'alkyle répondant à la formule générale R^{A}Cp⁻, dans laquelle R^{A} est choisi dans le groupe constitué de groupements alkyle linéaires renfermant 1 à 10 atomes de carbone et de groupements alkyle ramifiés renfermant 3 à 10 atomes de carbone, et
- des anions cyclopentadiénide polysubstitués à l'alkyle répondant à la formule générale R^{B}R^{C}R^{D}R^{E}R^{F}Cp⁻,
les radicaux R^{B}, R^{C}, R^{D}, R^{E} et R^{F} étant choisis, indépendamment les uns des autres, dans le groupe constitué d'hydrogène (H), de groupements alkyle linéaires renfermant 1 à 10 atomes de carbone et de groupements alkyle ramifiés renfermant 3 à 10 atomes de carbone,
à condition qu'au moins deux des radicaux R^{B}, R^{C}, R^{D}, R^{E} et R^{F} ne représentent pas l'hydrogène (H);
ou
b) est un anion triazénide répondant à la formule générale (R¹-N₃-R²)⁻, les radicaux R¹ et R² étant choisis, de manière indépendante de l'anion triazénide L_{T}, dans le groupe constitué de groupements alkyle linéaires renfermant 1 à 10 atomes de carbone et de groupements alkyle ramifiés renfermant 3 à 10 atomes de carbone.

2. Complexe de métal selon la revendication 1, ledit lanthanoïde étant choisi dans le groupe constitué de
i. La, Ce, Pr, Nd, Sm, Eu, Gd, Tb, Dy, Ho, Er, Tm, Yb et Lu;
ou
ii. La, Ce, Pr, Nd, Sm, Eu, Gd, Tb, Er, Yb et Lu;
ou
iii. La, Ce, Pr, Nd, Eu, Gd, Er, Yb et Lu;
ou
iv. La, Ce, Nd, Eu, Er et Lu.

3. Complexe de métal selon la revendication 1 ou la revendication 2,
i. le ligand donneur de pi de type monoanionique Lc étant choisi dans le groupe constitué
- de l'anion cyclopentadiénide non substitué (C₅H₅⁻);
- d'anions cyclopentadiénide monosubstitués à l'alkyle répondant à la formule générale R^{A}Cp⁻, dans laquelle
le radical R^{A} est choisi dans le groupe constitué de méthyle, éthyle, propyle, butyle, pentyle et de leurs isomères;
- d'anions cyclopentadiénide polysubstitués à l'alkyle répondant à la formule générale R^{B}R^{C}R^{D}R^{E}R^{F}Cp⁻,
les radicaux R^{B}, R^{C}, R^{D}, R^{E} et R^{F} étant choisis, indépendamment les uns des autres, dans le groupe constitué d'hydrogène (H), de méthyle, éthyle, propyle, butyle, pentyle et de leurs isomères,
à condition qu'au moins deux des radicaux R^{B}, R^{C}, R^{D}, R^{E} et R^{F} ne représentent pas l'hydrogène (H);
et/ou
ii. au moins un des radicaux R¹ et R² de l'anion triazénide L_{T} étant choisi dans le groupe constitué de groupements alkyle linéaires renfermant 1 à 6 atomes de carbone et de groupements alkyle ramifiés renfermant 3 à 6 atomes de carbone.

4. Complexe de métal selon au moins une des revendications 1 à 3, le Ligand Lz représentant
a) un ligand donneur de pi de type monoanionique, le ligand donneur de pi de type monoanionique Lz étant choisi dans le groupe constitué
- de l'anion cyclopentadiénide non substitué (C₅H₅⁻);
- d'anions cyclopentadiénide monosubstitués à l'alkyle répondant à la formule générale R^{A}Cp⁻, dans laquelle le radical R^{A} est choisi dans le groupe constitué de méthyle, éthyle, propyle, butyle, pentyle et de leurs isomères;
- d'anions cyclopentadiénide polysubstitués à l'alkyle répondant à la formule générale R^{B}R^{C}R^{D}R^{E}R^{F}Cp⁻, les radicaux R^{B}, R^{C}, R^{D}, R^{E} et R^{F} étant choisis, indépendamment les uns des autres, dans le groupe constitué d'hydrogène (H), de méthyle, éthyle, propyle, butyle, pentyle et de leurs isomères,
à condition qu'au moins deux des radicaux R^{B}, R^{C}, R^{D}, R^{E} et R^{F}ne représentent pas l'hydrogène (H);
ou
b) un anion triazénide répondant à la formule générale (R¹-N₃-R²)⁻, au moins un des radicaux R¹ et R² de l'anion triazénide Lz étant choisi dans le groupe constitué de groupements alkyle linéaires renfermant 1 à 6 atomes de carbone et de groupements alkyle ramifiés renfermant 3 à 6 atomes de carbone.

5. Complexe de métal selon l'un ou plusieurs des revendications précédentes, le complexe de métal présentant l'une ou plusieurs de propriétés suivantes:
i. le radical R¹ et le radical R² de l'anion triazénide L_{T} sont choisis, indépendamment l'un de l'autre, dans le groupe constitué de méthyle, éthyle, propyle, butyle, pentyle et de leurs isomères;
ii. le radical R¹ et le radical R² de l'anion L_{T} sont identique;
iii. Lz est un ligand donneur de pi de type monoanionique,
le ligand donneur de pi de type monoanionique Lc et le ligand donneur de pi de type monoanionique Lz étant identiques;
iv. Lz représente un anion triazénide répondant à la formule générale (R¹-N₃-R²)⁻, le radical R¹ et le radical R² de l'anion triazénide L_{T} étant choisis, indépendamment l'un de l'autre, dans le groupe constitué de méthyle, éthyle, propyle, butyle, pentyle et de leurs isomères;
v. Lz représente un anion triazénide répondant à la formule générale (R¹-N₃-R²)⁻, le radical R¹ et le radical R² de l'anion triazénide L_{T} étant identiques;
vi. Lz représente un anion triazénide répondant à la formule générale (R¹-N₃-R²)⁻, l'anion triazénide L_{T} et l'anion triazénide Lz étant identiques.

6. Complexe de métal selon l'un ou plusieurs des revendications précédentes, l'atome central métallique M étant choisi dans le groupe constitué de Sc, Y, La, Ce, Nd, Eu, Er, Lu et Ti, et
A. le ligand Lz étant un ligand donneur de pi de type monoanionique,
i. le ligand donneur de pi de type monoanionique Lc ou le ligand donneur de pi de type monoanionique Lz étant choisi
ou
ii. le ligand donneur de pi de type monoanionique Lc et le ligand donneur de pi de type monoanionique Lz étant choisis, indépendamment l'un de l'autre,
dans le groupe constitué
- de l'anion cyclopentadiénide non substitué (C₅H₅⁻);
- d'anions cyclopentadiénide monosubstitués à l'alkyle répondant à la formule générale R^{A}Cp⁻, dans laquelle
le radical R^{A} est choisi dans le groupe constitué de méthyle, éthyle, *n*-propyle, *iso*-propyle, *n*-butyle, *iso*-butyle, *sec*-butyle et de *tert-*butyle;
- d'anions cyclopentadiénide polysubstitués à l'alkyle répondant à la formule générale R^{B}R^{C}R^{D}R^{E}R^{F}Cp⁻, dans laquelle
les radicaux R^{B}, R^{C}, R^{D}, R^{E} et R^{F} sont choisis, indépendamment les uns des autres, dans le groupe constitué d'hydrogène (H), de méthyle, éthyle, *n*-propyle, *iso*-propyle, *n*-butyle, *iso*-butyle, *sec-*butyle et de *tert*-butyle,
à condition qu'au moins deux des radicaux R^{B}, R^{C}, R^{D}, R^{E} et R^{F}, lesquels ne représentent pas l'hydrogène (H), sont identiques;
et
le radical R¹ et le radical R² de l'anion triazénide L_{T} étant choisis, indépendamment l'un de l'autre, dans le groupe constitué de méthyle, éthyle, *iso*-propyle, *iso*-butyle, *sec*-butyle et de *tert*-butyle;
ou
B. le ligand Lz étant un anion triazénide répondant à la formule générale (R¹-N₃-R²)⁻ dans laquelle
i. les radicaux R¹ et R² de l'un des anions triazénide L_{T} et Lz sont choisis, indépendamment l'un de l'autre, dans le groupe constitué de méthyle, éthyle, *iso*-propyle, *iso*-butyle, *sec*-butyle et de *tert-*butyle;
ou
ii. les radicaux R¹ et R² de l'anion triazénide L_{T} et les radicaux R¹ et R² de l'anion triazénide Lz sont choisis, à chaque instance et indépendamment l'un de l'autre, dans le groupe constitué de méthyle, éthyle, *iso*-propyle, *iso*-butyle, *sec*-butyle et de *tert*-butyle;
et
le ligand donneur de pi de type monoanionique Lc étant choisi dans la groupe constitué de
- de l'anion cyclopentadiénide non substitué (C₅H₅⁻);
- d'anions cyclopentadiénide monosubstitués à l'alkyle répondant à la formule générale R^{A}Cp⁻, dans laquelle
le radical R^{A} est choisi dans le groupe constitué de méthyle, éthyle, *n*-propyle, *iso*-propyle, *n*-butyle, *iso*-butyle, *sec*-butyle et de *tert-*butyle;
- d'anions cyclopentadiénide polysubstitués à l'alkyle répondant à la formule générale R^{B}R^{C}R^{D}R^{E}R^{F}Cp⁻, dans laquelle
les radicaux R^{B}, R^{C}, R^{D}, R^{E} et R^{F} sont choisis, indépendamment les uns des autres, dans le groupe constitué d'hydrogène (H), de méthyle, éthyle, *n*-propyle, *iso*-propyle, *n*-butyle, *iso*-butyle, *sec-*butyle et de *tert*-butyle,
à condition qu'au moins deux des radicaux R^{B}, R^{C}, R^{D}, R^{E} et R^{F}, lesquels ne représentent pas l'hydrogène (H), sont identiques.

7. Complexe de métal selon l'une ou plusieurs des revendications précédentes, le complexe de métal ayant la formule I.1 ou la formule I.2 ou la formule I.3 ou la formule I.4 ou la formule I.5 ou la formule I.6 ou la formule I.7 ou la formule I.8 ou la formule I.9 ou la formule 1.10 ou la formule I.11:

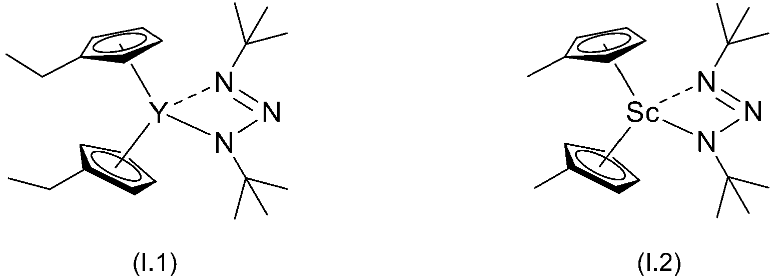

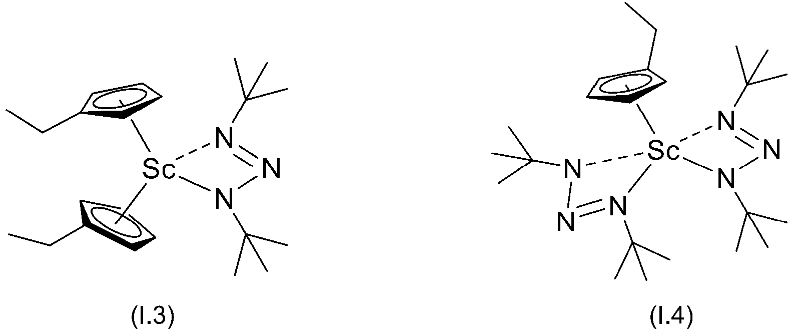

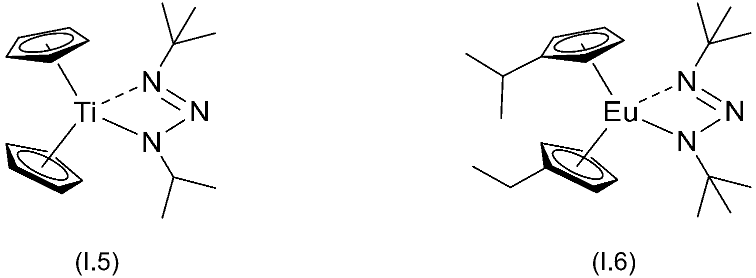

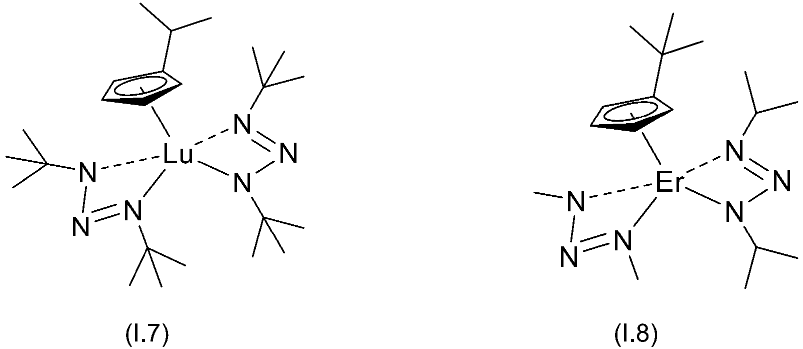

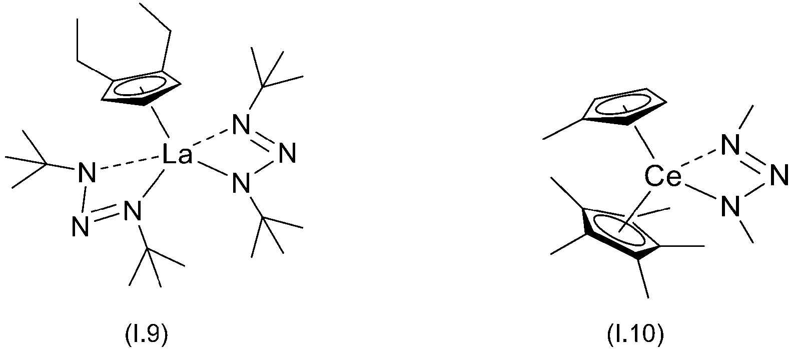

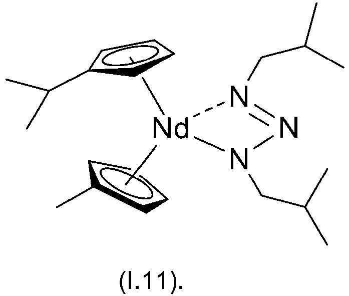

8. Complexe de métal selon l'une ou plusieurs des revendications précédentes,
i. le complexe de métal pouvant être évaporé sans se décomposer ou pouvant être sublimé sans se décomposer,
et/ou
ii. la masse moléculaire du complexe de métal étant inférieure à 600 g/mol.

9. Procédé de fabrication d'une couche, laquelle
i. est constituée d'au moins un métal M,
l'au moins un métal M étant choisi dans le groupe constitué de scandium, d'yttrium, de lanthanoïdes et de titane,
ou
ii. contenant au moins un métal M,
l'au moins un métal M étant choisi dans le groupe constitué de scandium, d'yttrium, de lanthanoïdes et de titane,
sur la surface d'un substrat, notamment d'un substrat de semi-conducteur, en utilisant
- au moins un complexe de métal répondant à la formule générale [M(L_{C})(L_{T})(L_{Z})] (I) selon l'une ou plusieurs des revendications 1 à 8,
ou
- une solution comprenant au moins un complexe de métal répondant à la formule générale [M(L_{C})(L_{T})(L_{Z})] (I) selon l'une ou plusieurs des revendications 1 à 8 et un solvant apolaire aprotique,
comprenant les étapes suivantes:
A. mise à disposition
- de l'au moins un complexe de métal répondant à la formule générale [M(L_{C})(L_{T})(L_{Z})] (I) selon l'une ou plusieurs des revendications 1 à 8,
ou
- de la solution comprenant au moins un complexe de métal répondant à la formule générale [M(L_{C})(L_{T})(L_{Z})] (I) selon l'une ou plusieurs des revendications 1 à 8 et un solvant apolaire aprotique,
et
B. dépôt de la couche laquelle
i. est constituée de l'au moins un métal M,
ou
ii. contient l'au moins un métal M,
sur la surface dudit substrat en utilisant l'au moins un complexe de métal, tel que mis à disposition à l'étape A, en tant que composé précurseur.

10. Procédé de fabrication d'un composant électronique, s'agissant notamment d'un composant électronique semi-conducteur, en utilisant
- au moins un complexe de métal répondant à la formule générale [M(L_{C})(L_{T})(L_{Z})] (I) selon l'une ou plusieurs des revendications 1 à 8,
ou
- une solution comprenant au moins un complexe de métal répondant à la formule générale [M(L_{C})(L_{T})(L_{Z})] (I) selon l'une ou plusieurs des revendications 1 à 8 et un solvant apolaire aprotique,
comprenant les étapes suivantes :
A. mise à disposition
- de l'au moins un complexe de métal répondant à la formule générale [M(L_{C})(L_{T})(L_{Z})] (I) selon l'une ou plusieurs des revendications 1 à 8,
ou
- de la solution comprenant au moins un complexe de métal répondant à la formule générale [M(L_{C})(L_{T})(L_{Z})] (I) selon l'une ou plusieurs des revendications 1 à 8 et un solvant apolaire aprotique,
B. dépôt d'une couche laquelle
i. est constituée de l'au moins un métal M,
ou
ii. contient l'au moins un métal M,
sur la surface d'un substrat,
et
C. finalisation du composant électronique, s'agissant notamment dudit composant électronique semi-conducteur.
